(19) Europäisches Patentamt
European Patent Office
Office européen des brevets

(11) EP 4 169 711 A1

(12) **EUROPEAN PATENT APPLICATION**
published in accordance with Art. 153(4) EPC

(43) Date of publication:
**26.04.2023 Bulletin 2023/17**

(21) Application number: **21829822.2**

(22) Date of filing: **03.06.2021**

(51) International Patent Classification (IPC):
***B32B 27/00*** *(2006.01)*

(52) Cooperative Patent Classification (CPC):
**B32B 27/00**

(86) International application number:
**PCT/JP2021/021113**

(87) International publication number:
**WO 2021/261195 (30.12.2021 Gazette 2021/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.06.2020 JP 2020107837**

(71) Applicant: **LINTEC CORPORATION**
**Itabashi-ku**
**Tokyo 173-0001 (JP)**

(72) Inventors:
- **KINOSHITA, Hiroki**
**Tokyo 173-0001 (JP)**
- **NAGANAWA, Satoshi**
**Tokyo 173-0001 (JP)**

(74) Representative: **Gille Hrabal**
**Partnerschaftsgesellschaft mbB**
**Patentanwälte**
**Brucknerstraße 20**
**40593 Düsseldorf (DE)**

(54) **OPTICAL FILM, OPTICAL FILM MANUFACTURING METHOD, TRANSPARENT CONDUCTIVE FILM, AND GAS BARRIER FILM**

(57) Provided is an optical film that is thin, excellent in heat resistance, and suitable for formation of a functional layer such as a transparent conductive layer or a gas barrier layer. An optical film including a casting film; and a cured resin layer, wherein the cured resin layer is a layer including a cured product of a curable resin composition containing a polymer component (A) and a curable monomer (B), and satisfies that [a] (I) in a curve representing a change in loss tangent with respect to a temperature regarding characteristic value obtained by dynamic viscoelasticity measurement at a heating rate of 3°C/sec from 25°C to 280°C, one or more loss tangent peaks are present, and peak temperatures of all loss tangent peaks are 150°C or higher, and (II) a storage modulus reduction rate, which is a reduction rate of the storage modulus from 25°C to 150°C is 40% or less, or [b] a glass transition temperature of the polymer component (A) is 250°C or higher, and in the curve, one or more loss tangent peaks are present, and peak temperatures of all loss tangent peaks are 150°C or higher.

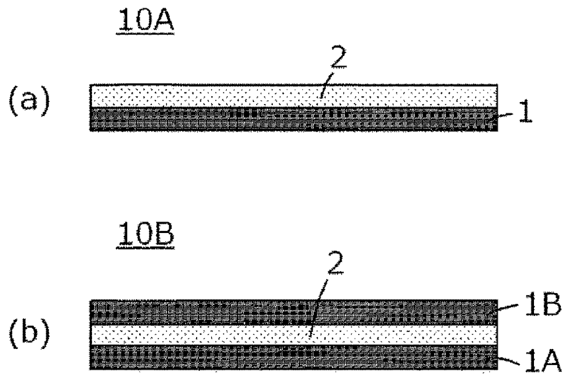


Fig. 1

EP 4 169 711 A1

## Description

[Technical Field]

The present invention relates to an optical film, an optical film manufacturing method, a transparent conductive film, and a gas barrier film.

[Background Art]

A transparent conductive film in which a transparent conductive layer is formed on a surface of a substrate film is used in a liquid crystal display; an electroluminescence (EL) display; an electrochromic (EC) display; a solar cell; an electromagnetic shielding film for an electromagnetic shield; a film sensor, such as a transparent touch panel; and the like.

In the process of manufacturing a transparent conductive film, the processing is often performed under harsh conditions involving heating, such as sputtering of a metal compound and subsequent annealing treatment. Thus, high heat resistance is required for an optical film serving as a substrate on which a transparent conductive layer is to be formed. A conceivable solution for this issue is to use an optical film having heat resistance, and such an optical film is formed from a highly heat-resistant resin (for example, a resin having a glass transition temperature of 250°C or higher), such as a polyimide resin.

A gas barrier film has been also widely used as a substrate material and a sealing material. The gas barrier film has a high gas barrier property that can suppress transmission of water vapor, oxygen and the like. In addition, for example, the gas barrier film is required to have higher translucency so as not to impair the visibility of the object to which the gas barrier film is attached, such as an electronic device, and is required not to compromise the lightweight property of the object to be attached.

In consideration of the above viewpoint, it is known that an optical film is manufactured by applying a curable composition containing a curable compound to a support and curing the curable compound contained in the obtained coating layer to form a thin cured resin layer, and, on a cured resin layer of the optical film, a gas barrier layer including an inorganic film or the like is formed directly or via another layer. Hereinafter, a property of suppressing the permeation of the water vapor, oxygen, or the like is referred to as a "gas barrier property", a layer having a gas barrier property is referred to as a "gas barrier layer", and a film having a gas barrier layer is referred to as a "gas barrier film".

For example, Patent Document 1 discloses that using a curable resin composition containing a resin such as a polysulfone-based resin and a curable monomer, a cured resin layer is formed on a process sheet and a gas barrier layer is formed on the cured resin layer. Such a manufacturing method provides a gas barrier film having a cured resin layer positioned on one surface and a gas barrier layer positioned on the other surface can be obtained.

In recent years, there has been a demand for thinner optical films in order to further improve the transparency and flexibility of a transparent conductive film and a gas barrier film and to further reduce their weight.

[Citation List]

[Patent Literature]

Patent Document 1: WO 2013/065812

[Summary of Invention

[Technical Problem]

A known optical film including a curable resin layer has the following problems.

First, for example, the cured resin layer is required to have solvent resistance to resist damage caused by a solvent when a liquid such as a coating liquid of a polysilazane-based gas barrier layer or a dispersion liquid of silver nanowire for a transparent conductive layer is applied to the cured resin layer. In addition, when the optical film is exposed to a high temperature, it needs to withstand a thermal load during the formation of a transparent conductive layer, a gas barrier layer, or the like, through suppression in a large decrease in storage modulus or an increase in linear expansion coefficient.

These properties are particularly desired as the need for thinner optical films increases for transparency and weight reduction, and further improvement is required.

In view of the above problems, an object of the present invention is to provide an optical film that is thin, excellent in heat resistance, and facilitates the formation of a functional layer such as a transparent conductive layer or a gas barrier layer, and a method for manufacturing the same. Another object of the present invention is to provide a transparent

conductive film and a gas barrier film which are easy to manufacture, thin, and have excellent heat resistance.

[Solution to Problem]

As a result of diligent studies to solve the above problems, the present inventors have found that the above problems can be solved by an optical film including a casting film and a cured resin layer, in which a cured resin layer includes a cured product of a curable resin composition, has peak temperatures of all loss tangent peaks at a predetermined temperature or higher in a measurement curve obtained by dynamic viscoelasticity measurement of the cured resin layer, and further exhibits predetermined physical properties, thereby completing the present invention.

That is, the present invention provides the following [1] to [6].

[1] An optical film including a casting film and a cured resin layer, wherein the cured resin layer is a layer including a cured product of a curable resin composition containing a polymer component (A) and a curable monomer (B), and satisfies (I) and (II) below for characteristic values determined by dynamic viscoelasticity measurement at a heating rate of 3°C/sec from 25°C to 280°C:

(I) one or more loss tangent peaks are present in a curve representing a change in loss tangent with respect to temperature, and peak temperatures of all loss tangent peaks are 150°C or higher,
(II) a storage modulus reduction rate is 40% or less, the storage modulus reduction rate being a reduction rate of the storage modulus from 25°C to 150°C, calculated by Equation (1) below:

$$\text{storage modulus reduction rate} = (\text{storage modulus at } 25°C - \text{storage modulus at } 150°C)/\text{storage modulus at } 25°C \times 100\ (\%) \ldots \quad \text{Equation (1)}.$$

[2] An optical film including a casting film and a cured resin layer, wherein the cured resin layer is a layer including a cured product of a curable resin composition containing a polymer component (A) and a curable monomer (B), a glass transition temperature of the polymer component (A) is 250°C or higher, and in a curve representing a change in loss tangent with respect to a temperature obtained by dynamic viscoelasticity measurement at a heating rate of 3°C/sec from 25°C to 280°C, one or more loss tangent peaks are present, and peak temperatures of all loss tangent peaks are 150°C or higher.
[3] The optical film according to [1] or [2], wherein a thickness of the cured resin layer is 20 μm or less.
[4] An optical film manufacturing method, the method including:

a first step of forming a curable resin layer made of a curable resin composition containing a polymer component (A) and a curable monomer (B) on a casting film;
a second step of irradiating the curable resin layer with at least one of an energy ray or an electron beam to cure at least a part of the curable resin layer; and
a third step of performing a heat treatment of heating the curable resin layer to 150°C or higher on or after the start of the second step to form a cured resin layer.

[5] A transparent conductive film including: the optical film described in any one of [1] to [3]; and a transparent conductive layer provided on the cured resin layer of the optical film.
[6] A gas barrier film including: the optical film described in any one of [1] to [3]; and a gas barrier layer provided on the cured resin layer of the optical film.

[Advantageous Effects of Invention]

According to the present invention, it is possible to provide an optical film that is thin, excellent in heat resistance, and facilitates formation of a functional layer such as a transparent conductive layer or a gas barrier layer, and a method for manufacturing the same. In addition, according to the present invention, it is possible to provide a transparent conductive film and a gas barrier film which are easy to manufacture, thin, and have excellent heat resistance.

[Brief Description of Drawings]

Fig. 1 is a cross-sectional schematic view illustrating an example of a configuration of an optical film according to an embodiment of the present invention.

Fig. 2 is a cross-sectional schematic view illustrating an example of a configuration of a transparent conductive film and a gas barrier film according to an embodiment of the present invention.

Fig. 3 is a process chart illustrating an example of an optical film manufacturing method.

[Description of Embodiments]

In the present specification, the description "from XX to YY" means "XX or higher and YY or lower" or "XX or greater and YY or less".

In the present specification, for example, "(meth)acrylic acid" refers to both "acrylic acid" and "methacrylic acid", and the same is true of other similar terms.

An optical film according to an embodiment of the present invention will be described below.

1. Optical film

An optical film according to an embodiment of the present invention includes a casting film and a cured resin layer. In addition, in the optical film, the cured resin layer is a layer includes a cured product of a curable resin composition containing a polymer component (A) and a curable monomer (B), and (I) and (II) below are satisfied for characteristic values obtained by dynamic viscoelasticity measurement at a heating rate of 3°C/sec from 25°C to 280°C.

(I) one or more loss tangent peaks are present in a curve representing a change in loss tangent with respect to temperature, and peak temperatures of all loss tangent peaks are 150°C or higher,

(II) a storage modulus reduction rate, which is a reduction rate of the storage modulus from 25°C to 150°C, calculated by Equation (1) below is 40% or less.

$$\text{Storage modulus reduction rate} = (\text{storage modulus at } 25°\text{C} - \text{storage modulus at } 150°\text{C})/\text{storage modulus at } 25°\text{C} \times 100\ (\%) \quad \text{... Equation (1)}$$

As a result of diligent research, the present inventors found the following matters:

(i) When the cured resin layer includes a cured product of a curable resin composition containing the polymer component (A) and the curable monomer (B), such a cured resin layer can exert effects such as improvement in solvent resistance and peelability from the casting film. (ii) In addition, for the characteristic value determined by dynamic viscoelasticity measurement under a heating rate of 3°C/sec from 25°C to 280°C, if (I) below is satisfied, it is possible to reduce the change in storage modulus and linear expansion coefficient of the cured resin layer at high temperatures: (I) one or more loss tangent peaks are present in a curve representing a change in loss tangent with respect to temperature change, and peak temperatures of all loss tangent peaks are 150°C or higher. Furthermore, if (II) below is satisfied, the optical film can withstand a thermal load during the formation of a functional layer such as a transparent conductive layer or a gas barrier layer: (II) when the storage modulus reduction rate, which is the reduction rate of the storage modulus from 25°C to 150°C calculated by the above Equation (1), is 40% or less. (iii) Further, since the curable resin composition contains a curable monomer, generation of a curl after the peeling of the casting film can be suppressed, and the casting film is easily peeled off.

An optical film according to another embodiment of the present invention includes a casting film and a cured resin layer. In addition, the cured resin layer is a layer including a cured product of a curable resin composition containing a polymer component (A) and a curable monomer (B), a glass transition temperature of the polymer component (A) is 250°C or higher, and in a curve representing a change in loss tangent with respect to a temperature determined by dynamic viscoelasticity measurement at a heating rate of 3°C/sec from 25°C to 280°C, one or more loss tangent peaks are present, and peak temperatures of all loss tangent peaks are 150°C or higher.

As a result of diligent research, the present inventors found the following matters:
In addition to the items (i) and (iii), (iv) when the glass transition temperature of the polymer component (A) is 250°C or higher, one or more loss tangent peaks are present and peak temperatures of all loss tangent peaks are 150°C or higher, in a curve representing a change in loss tangent with respect to temperature change, determined in dynamic viscoelasticity measurement under a heating rate of 3°C/sec from 25°C to 280°C, it is possible to reduce the change in storage modulus and linear expansion coefficient of the cured resin layer at high temperatures.

The loss tangent peak is determined by performing peak separation using a Gaussian function as a fitting function on a curve representing a change in loss tangent with respect to a temperature obtained by dynamic viscoelasticity measurement at a heating rate of 3°C/sec from 25°C to 280°C. Then, the temperature at each peak apex is defined as the peak temperature. The peak temperature of the loss tangent peak is specifically measured by the method described in examples.

When the peak temperature of all the loss tangent peaks is 150°C or higher, there is no loss tangent peak in the temperature region lower than 150°C. Therefore, for example, even when the heating temperature at the time of formation of the transparent conductive material layer by sputtering, the heating temperature at the time of annealing of the transparent conductive material layer containing silver nanofillers or the like, or the heating temperature for formation of the gas barrier layer reaches about 150°C, the optical film is less likely to be deformed by heating, and facilitating easy formation of the transparent conductive layer or the gas barrier layer. Thus, a transparent conductive film or a gas barrier film that ensures necessary conductivity and gas barrier properties can be easily formed. From this perspective, the peak temperatures of all loss tangent peaks are more preferably 200°C or higher.

As a method for making the peak temperatures of all the loss tangent peaks of the optical film to be 150°C or higher in the measurement curve of the loss tangent obtained by the dynamic viscoelasticity measurement described above, the third step may be performed in an optical film manufacturing method described later.

In an optical film according to an embodiment of the present invention, as defined in (II) above, the storage modulus reduction rate, which is a reduction rate of the storage modulus from 25°C to 150°C, is 40% or less as calculated by the above Equation (1). The storage modulus reduction rate is preferably 35% or less, more preferably 30% or less. The storage modulus reduction rate is specifically measured by the method described in examples.

When the storage modulus reduction rate is in the range described above, the optical film can withstand thermal load during the formation of a functional layer such as a transparent conductive layer or a gas barrier layer.

Examples of the method for making the storage modulus reduction rate to be within the above range include the use of a resin having a high glass transition temperature as the polymer component (A) as described later.

Hereinafter, for ease of understanding, the configuration of each layer and the film will be described with reference to the drawings or using the symbols indicated in the drawings as appropriate, but the present invention is not limited to the illustrated embodiments.

A specific example of a configuration of an optical film according to an embodiment of the present invention is illustrated in Fig. 1.

An optical film 10A illustrated in Fig. 1(a) has a casting film 1 on one surface of a cured resin layer 2. As described later, a functional layer such as a transparent conductive layer or a gas barrier layer is provided on a surface of the cured resin layer 2, the surface being opposite to the surface on which the casting film 1 is provided, and the cured resin layer 2 is used as a transparent conductive film or a gas barrier film.

An optical film 10B illustrated in Fig. 1(b) has casting films 1A and 1B each on both surfaces of the cured resin layer 2. When the functional layer such as the transparent conductive layer or the gas barrier layer is provided, any of the casting films 1A and 1B is peeled off and removed. Then, the functional layer such as the transparent conductive layer or the gas barrier layer is provided on the exposed surface.

### 1-1. Cured resin layer

The cured resin layer included in the optical film according to an embodiment of the present invention includes a cured product of the curable resin composition containing the polymer component (A) and the curable monomer (B). The cured resin layer may be a single layer or may include a plurality of laminated layers.

### Polymer component (A)

In the optical film according to an embodiment of the present invention, a glass transition temperature (Tg) of the polymer component (A) is 250°C or higher. The Tg of the polymer component (A) is preferably 290°C or higher, and more preferably 320°C or higher. When the Tg of the polymer component (A) is 250°C or higher, decrease in heat resistance can be avoided easily, due to the effect of a polymer produced when a curable composition is prepared with the curable monomer (B) described later and the curable composition is cured. As a result, a change in the storage modulus and the linear expansion coefficient of the cured resin layer at a high temperature can be reduced. Thus, when a functional layer such as a transparent conductive layer or a gas barrier layer is formed, it is easy to prevent the cured resin layer from being affected by heating during film formation or being deformed by heating such as annealing treatment.

Here, "Tg" refers to a temperature at the maximum loss tangent (tan6), the loss tangent being represented by loss modulus/storage modulus, obtained by viscoelasticity measurement (measured under a tensile mode with a frequency of 11 Hz, a heating rate of 3°C/minute, and a range of from 0 to 250°C).

The weight average molecular weight (Mw) of the polymer component (A) is preferably 100000 or greater, more

preferably 200000 or greater, and preferably 1000000 or less, more preferably 800000 or less, even more preferably 500000 or less.

In addition, the molecular weight distribution (Mw/Mn) of the polymer component (A) is in a range preferably of 1.0 to 5.0 and more preferably of 2.0 to 4.5. The weight average molecular weight (Mw) and molecular weight distribution (Mw/Mn) are values measured by gel permeation chromatography (GPC) in terms of polystyrene. The polymer component (A) with a Mw of 100000 or greater facilitates an increase in elongation at break of the cured resin layer.

The polymer component (A) is preferably a thermoplastic resin, more preferably an amorphous thermoplastic resin. The use of an amorphous thermoplastic resin makes it easier to form a cured resin layer having excellent optical isotropy and an optical film having excellent transparency. In addition, an amorphous thermoplastic resin is generally easily soluble in an organic solvent, and thus the cured resin layer can be efficiently formed by a solution casting method as described later.

Here, the amorphous thermoplastic resin refers to a thermoplastic resin for which a melting point is not observed in differential scanning calorimetry.

The polymer component (A) is preferably soluble particularly in a general-purpose organic solvent with a low boiling point, such as ethyl acetate and methyl ethyl ketone (MEK). The polymer component (A) soluble in a general-purpose organic solvent makes it easier to form the cured resin layer by coating.

A particularly preferred material as the polymer component (A) is an amorphous thermoplastic resin having a Tg of 250°C or higher and soluble in a general-purpose organic solvent having a low boiling point, such as ethyl acetate and methyl ethyl ketone.

Furthermore, from the viewpoint of heat resistance, the polymer component (A) is preferably a thermoplastic resin having a ring structure such as an aromatic ring structure or an alicyclic structure, more preferably a thermoplastic resin having an aromatic ring structure.

Specific examples of the polymer component (A) include: a polyimide resin; and a polyarylate resin having a Tg of 250°C or higher. In general, these resins have a high Tg and excellent heat resistance; furthermore, since these resins are amorphous thermoplastic resins, coating formation by a solution casting method is possible. Of these, a polyimide resin is preferable due to its high Tg and excellent heat resistance, and the fact that it is easy to obtain a polyimide resin that exhibits good heat resistance and that is soluble in a general-purpose organic solvent.

The polyimide resin is not particularly limited as long as the effect of the present invention is not impaired. Examples of the polyimide resin that can be used include an aromatic polyimide resin, an aromatic (carboxylic acid component)-cyclic aliphatic (diamine component) polyimide resin, a cycloaliphatic (carboxylic acid component)-aromatic (diamine component) polyimide resin, a cycloaliphatic polyimide resin, and a fluorinated aromatic polyimide resin. In particular, a polyimide resin having a fluoro group in the molecule is preferable.

Specifically, the polyimide resin is preferably produced by preparing a polyamic acid by the polymerization of an aromatic diamine compound and a tetracarboxylic dianhydride and then subjecting the resulting polyamic acid to a chemical imidization reaction.

For an aromatic diamine compound, any aromatic diamine compound can be used as long as it is one that, via the reaction with tetracarboxylic dianhydride which is used together, gives a polyimide that is soluble in a common solvent (for example, N,N-dimethylacetamide (DMAC)) and has a predetermined transparency. Specific examples include m-phenylenediamine, p-phenylenediamine, 3,4'-diaminodiphenyl ether, 4,4'-diaminodiphenyl ether, 3,3'-diaminodiphenyl sulfide, 3,4'-diaminodiphenyl sulfide, 4,4'-diaminodiphenyl sulfide, 3,3'-diaminodiphenyl sulfone, 3,4'-diaminodiphenyl sulfone, 4,4'-diaminodiphenyl sulfone, 3,3'-diaminobenzophenone, 3,3'-diaminodiphenylmethane, 3,4'-diaminodiphenylmethane, 4,4'-diaminodiphenylmethane, 2,2-bis(4-aminophenyl)propane, 2,2-bis(3-aminophenyl)propane, 2-(3-aminophenyl)-2-(4-aminophenyl)propane, 2,2-bis(4-aminophenyl)-1,1,1,3,3,3-hexafluoropropane, 2,2-bis(3-aminophenyl)-1,1,1,3,3,3-hexafluoropropane, 2-(3-aminophenyl)-2-(4-aminophenyl)-1,1,1,3,3,3-hexafluoropropane, 1,3-bis(3-aminophenoxy)benzene, 1,3-bis(4-aminophenoxy)benzene, 1,4-bis(3-aminophenoxy)benzene, 1,4-bis(4-aminophenoxy)benzene, 4,4'-bis(4-aminophenoxy)biphenyl, 3,3'-bis(4-aminophenoxy)biphenyl, 3,4'-bis(3-aminophenoxy)biphenyl, bis[4-(4-aminophenoxy)phenyl]sulfide, bis[3-(4-aminophenoxy)phenyl]sulfide, bis[4-(3-aminophenoxy)phenyl] sulfide, bis[3-(4-aminophenoxy)phenyl]sulfide, bis[3-(3-aminophenoxy)phenyl]sulfide, bis[3-(4-aminophenoxy)phenyl]sulfone, bis[4-(4-aminophenyl)]sulfone, bi s [3 -(3 -aminophenoxy)phenyl] sulfone, bis[4-(3-aminophenyl)]sulfone, bis[4-(3-aminophenoxy)phenyl]ether, bis[4-(4-aminophenoxy)phenyl]ether, bi s [3 -(3 -aminophenoxy)phenyl] ether, bis[4-(3-aminophenoxy)phenyl]methane, bis[4-(4-aminophenoxy)phenyl]methane, bis[3-(3-aminophenoxy)phenyl]methane, bis[3-(4-aminophenoxy)phenyl]methane, 2,2-bis[4-(3-aminophenoxy)phenyl]propane, 2,2-bis[4-(4-aminophenoxy)phenyl]propane, 2,2-bis[3-(3-aminophenoxy)phenyl]propane, 2,2-bis[4-(3-aminophenoxy)phenyl]-1,1,1,3,3,3-hexafluoropropane, 2,2-bis[4-(4-aminophenoxy)phenyl]-1,1,1,3,3,3-hexafluoropropane, 2,2-bis[3-(3-aminophenoxy)phenyl]-1,1,1,3,3,3-hexafluoropropane, 2,2-bis[3-(4-aminophenoxy)phenyl]-1,1,1,3,3,3-hexafluoropropane, 1,3-bis[4-(4-amino-6-trifluoromethylphenoxy)-α,α-dimethylbenzyl]benzene, 1,3-bis[4-(4-amino-6-fluoromethylphenoxy)-α,α-dimethylbenzyl]benzene, 2,2'-dimethyl-4,4'-diaminobiphenyl, 3,3'-dimethyl-4,4'-diaminobiphenyl, 3,3'-bis(trifluoromethyl)-4,4'-diaminobiphenyl, and 2,2'-bis(trifluoromethyl)-4,4'-diaminobiphenyl.

These aromatic diamine compounds may be used alone or in a combination of two or more. Furthermore, from the viewpoint of transparency and heat resistance, preferable aromatic diamine compounds are the ones having a fluoro group, such as 2,2-bis(4-aminophenyl)-1,1,1,3,3,3-hexafluoropropane, 2,2-bis(3-aminophenyl)-1,1,1,3,3,3-hexafluoropropane, 2-(3-aminophenyl)-2-(4-aminophenyl)-1,1,1,3,3,3-hexafluoropropane, 2,2-bis[4-(3-aminophenoxy)phenyl]-1,1,1,3,3,3-hexafluoropropane, 2,2-bis[4-(4-aminophenoxy)phenyl]-1,1,1,3,3,3-hexafluoropropane, 2,2-bis[3-(3-aminophenoxy)phenyl]-1,1,1,3,3,3-hexafluoropropane, 2,2-bis[3-(4-aminophenoxy)phenyl]-1,1,1,3,3,3-hexafluoropropane, 1,3-bis[4-(4-amino-6-trifluoromethylphenoxy)-$\alpha$,$\alpha$-dimethylbenzyl]benzene, 3,3'-bis(trifluoromethyl)-4,4'-diaminobiphenyl, and 2,2'-bis(trifluoromethyl)-4,4'-diaminobiphenyl. At least one aromatic diamine compound to be used is preferably one having a fluoro group, and is particularly preferably 2,2'-bis(trifluoromethyl)-4,4'-diaminobiphenyl. Using an aromatic diamine compound having a fluoro group facilitates the formation of polyimide having transparency, heat resistance, and solubility in a solvent.

Similar to the description of aromatic diamine compound above, any tetracarboxylic dianhydride can be used as long as it is one that gives a polyimide that is soluble in a common solvent (for example, N,N-dimethylacetamide (DMAC)) and has a predetermined transparency. Specific examples of the tetracarboxylic dianhydride include 4,4'-(1,1,1,3,3,3-hexafluoropropane-2,2-diyl)diphthalic acid dianhydride, pyromellitic dianhydride, 3,3',4,4'-benzophenone tetracarboxylic dianhydride, 1,4-hydroquinone dibenzoate-3,3',4,4'-tetracarboxylic dianhydride, 3,3',4,4'-biphenyltetracarboxylic dianhydride, and 3,3',4,4'-diphenylether tetracarboxylic dianhydride. These tetracarboxylic dianhydrides may be used alone or in a combination of two or more types. Furthermore, from the viewpoint of transparency, heat resistance, and solubility in a solvent, it is preferable to use a tetracarboxylic dianhydride having at least one type of fluoro group, such as 4,4'-(1,1,1,3,3,3-hexafluoropropane-2,2-diyl)diphthalic acid dianhydride.

The polymerization for preparing polyamic acid can be performed by reacting the aromatic diamine compound and tetracarboxylic dianhydride under their dissolution in a solvent in which the resulting polyamic acid is soluble. Examples of the solvent that can be used as the solvent used in the polymerization for preparing polyamic acid include N,N-dimethylacetamide, N,N-dimethylformamide, N-methyl-2-pyrrolidone, 1,3-dimethyl-2-imidazolidinone, and dimethyl sulfoxide.

The polymerization reaction for preparing polyamic acid is preferably performed while stirring in a reaction vessel provided with a stirring device. Examples include: a method of producing polyamic acid in which the reaction is carried out by dissolving a predetermined amount of an aromatic diamine compound in the solvent and adding a tetracarboxylic dianhydride to the solvent while stirring; a method of producing polyamic acid in which the reaction is carried out by dissolving a tetracarboxylic dianhydride in the solvent and adding an aromatic diamine compound while stirring; and a method of producing polyamide acid in which the reaction is carried out by adding an aromatic diamine compound and a tetracarboxylic dianhydride alternately to the solvent.

While the temperature of the polymerization reaction for preparing polyamic acid is not particularly limited, the polymerization reaction is preferably performed at a temperature of from 0 to 70°C, more preferably from 10 to 60°C, and even more preferably from 20 to 50°C. When the polymerization reaction is performed within the ranges described above, a high molecular weight polyamic acid that is less colored and has excellent transparency can be produced.

In addition, while the aromatic diamine compound and tetracarboxylic dianhydride used in the polymerization for preparing polyamic acid are generally used in an equivalent amount, the molar ratio of the tetracarboxylic dianhydride to the aromatic diamine compound can be modified. That is, the molar amount of the tetracarboxylic dianhydride/the molar amount of the aromatic diamine compound, may be modified within a range of from 0.95 to 1.05 so as to control the degree of polymerization of the resulting polyamic acid. The molar ratio of the tetracarboxylic dianhydride to the aromatic diamine compound is preferably in a range of from 1.001 to 1.02, more preferably from 1.001 to 1.01. Making the tetracarboxylic dianhydride in a slight excess with respect to the aromatic diamine compound, as described above, can stabilize the degree of polymerization of the resulting polyamic acid, and can arrange a unit derived from the tetracarboxylic dianhydride to be placed at the end of the polymer. As a result, a polyimide that is less colored and has excellent transparency can be produced.

The concentration of the resulting polyamic acid solution is preferably adjusted to an appropriate value (for example, approximately from 10 to 30 mass%) so that the viscosity of the solution is properly maintained and thus the solution can be easily handled in a subsequent process.

An imidizing agent is added to the resulting polyamic acid solution and a chemical imidization reaction is carried out. Examples of the imidizing agent include carboxylic anhydrides such as acetic anhydride, propionic anhydride, succinic anhydride, phthalic anhydride, and benzoic anhydride; acetic anhydride is preferred from the viewpoint of cost and ease of removal after reaction. The equivalent weight of the imidizing agent to be used is greater than or equal to the equivalent weight of the amide bond of the polyamic acid that participates in the chemical imidization reaction, and is preferably from 1.1 to 5 times, more preferably from 1.5 to 4 times, the equivalent weight of the amide bond. Using a slight excess of the imidizing agent with respect to the amide bond, as described above, facilitates the efficient imidization reaction even at a relatively low temperature.

Aliphatic, aromatic, or heterocyclic tertiary amines such as pyridine, picoline, quinoline, isoquinoline, trimethylamine, and triethylamine can be used as an imidization accelerator for the chemical imidization reaction. Using these amines facilitates the efficient imidization reaction at a low temperature. As a result, coloration during the imidization reaction can be suppressed and a more transparent polyimide can be formed easily.

While the temperature of the chemical imidization reaction is not particularly limited, the reaction is preferably performed at a temperature of 10°C or higher and lower than 50°C, and more preferably 15°C or higher and lower than 45°C. Performing the chemical imidization reaction at a temperature of 10°C or higher and lower than 50°C can suppress coloration during the imidization reaction, and thus can provide a polyimide with excellent transparency.

Thereafter, if necessary, powder formation and drying are performed; the powder formation is carried out by adding a poor solvent for polyimide to the polyimide solution resulting from the chemical imidization reaction to precipitate the polyimide and form a powder.

The polyimide resin is preferably soluble in an organic solvent having a low boiling point such as benzene or methyl ethyl ketone. In particular, the polyimide resin is preferably soluble in methyl ethyl ketone. The polyimide resin soluble in methyl ethyl ketone can easily form a layer of the curable resin composition by coating and drying.

A polyimide resin containing a fluoro group is particularly preferred from the viewpoints that it is easily dissolved in a general-purpose organic solvent with a low boiling point, such as methyl ethyl ketone, and that it facilitates formation of the cured resin layer by a coating method.

The polyimide resin having a fluoro group is preferably an aromatic polyimide resin having a fluoro group in the molecule, and preferably has a skeleton represented by the following chemical formula in the molecule.

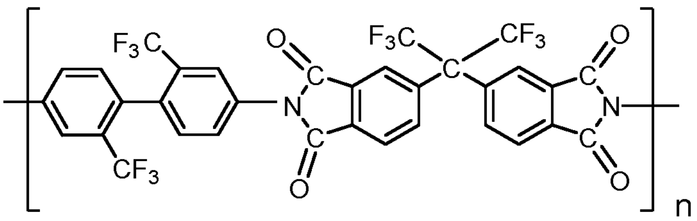

A polyimide resin having a skeleton represented by the above chemical formula has a very high Tg, which is higher than 300°C, due to the high rigidity of the skeleton described above. Thus, this can greatly improve heat resistance of the cured resin layer. In addition, the skeleton described above is straight and has a relatively high flexibility and readily increases the elongation at break of the cured resin layer. Furthermore, the polyimide resin having the skeleton described above has a fluoro group and thus can be dissolved in a general-purpose organic solvent with a low boiling point, such as methyl ethyl ketone. Thus, the cured resin layer can be formed as a coating by performing coating by a solution casting method, and the solvent can also be easily removed by drying. A polyimide resin having the skeleton represented by the chemical formula above can be formed by the polymerization for preparing polyamic acid and imidization reaction described above using 2,2'-bis(trifluoromethyl)-4,4'-diaminobiphenyl and 4,4'-(1,1,1,3,3,3-hexafluoropropane-2,2-diyl)diphthalic acid dianhydride.

The polyarylate resin is a resin made from a polymer compound formed by the reaction between an aromatic diol and an aromatic dicarboxylic acid or a chloride of an aromatic dicarboxylic acid. The polyarylate resin also has a relatively high Tg and relatively good elongation properties. The polyarylate resin is not particularly limited, and a known resin can be used.

Examples of the aromatic diol include: bis(hydroxyphenyl)alkanes, such as bis(4-hydroxyphenyl)methane [bisphenol F], bis(3-methyl-4-hydroxyphenyl)methane, 1,1-bis(4'-hydroxyphenyl)ethane, 1,1-bis(3'-methyl-4'-hydroxyphenyl)ethane, 2,2-bis(4'-hydroxyphenyl)propane [bisphenol A], 2,2-bis(3'-methyl-4'-hydroxyphenyl)propane, 2,2-bis(4'-hydroxyphenyl)butane, and 2,2-bis(4'-hydroxyphenyl)octane; bis(hydroxyphenyl)cycloalkanes, such as 1,1-bis(4'-hydroxyphenyl)cyclopentane, 1,1-bis(4'-hydroxyphenyl)cyclohexane [bisphenol Z], and 1,1-bis(4'-hydroxyphenyl)-3,3,5-trimethylcyclohexane; bis(hydroxyphenyl)phenylalkanes, such as bis(4-hydroxyphenyl)phenylmethane, bis(3-methyl-4-hydroxyphenyl)phenylmethane, bis(2,6-dimethyl-4-hydroxyphenyl)phenylmethane, bis(2,3,6-trimethyl-4-hydroxyphenyl)phenylmethane, bis(3-t-butyl-4-hydroxyphenyl)phenylmethane, bis(3-phenyl-4-hydroxyphenyl)phenylmethane, bis(3-fluoro-4-hydroxyphenyl)phenylmethane, bis(3-bromo-4-hydroxyphenyl)phenylmethane, bis(4-hydroxyphenyl)-4-fluorophenylmethane, bis(3-fluoro-4-hydroxyphenyl)-4-fluorophenylmethane, bis(4-hydroxyphenyl)-4-chlorophenylmethane, bis(4-hydroxyphenyl)-4-bromophenylmethane, bis(3,5-dimethyl-4-hydroxyphenyl)-4-fluorophenylmethane, 1,1-bis(4'-hydroxyphenyl)-1-phenylethane [bisphenol P], 1,1-bis(3'-methyl-4'-hydroxyphenyl)-1-phenylethane, 1,1-bis(3'-t-butyl-4'-hydroxyphenyl)-1-phenylethane, 1,1-bis(3'-phenyl-4'-hydroxyphenyl)-1-phenylethane, 1,1-bis(4'-hydroxyphenyl)-1-(4'-nitrophenyl)ethane, 1,1-bis(3'-bromo-4'-hydroxyphenyl)-1 -phenylethane, 1,1-bis(4'-hydroxyphenyl)-1-phenylpropane, bis(4-hydroxyphenyl)diphenylmethane, and bis(4-hydroxyphenyl)dibenzylmethane; bis(hydroxyphenyl)ethers, such as bis(4-hydroxyphenyl)ether and bis(3-methyl-4-hydroxyphenyl)ether; bis(hydroxyphenyl)ketones,

such as bis(4-hydroxyphenyl)ketone and bis(3-methyl-4-hydroxyphenyl)ketone; bis(hydroxyphenyl)sulfides, such as bis(4-hydroxyphenyl)sulfide and bis(3-methyl-4-hydroxyphenyl)sulfide; bis(hydroxyphenyl)sulfoxides, such as bis(4-hydroxyphenyl)sulfoxide and bis(3-methyl-4-hydroxyphenyl)sulfoxide; bis(hydroxyphenyl)sulfones, such as bis(4-hydroxyphenyl)sulfone [bisphenol S] and bis(3-methyl-4-hydroxyphenyl)sulfone; and bis(hydroxyphenyl)fluorenes, such as 9,9-bis(4'-hydroxyphenyl)fluorene and 9,9-bis(3'-methyl-4'-hydroxyphenyl)fluorene.

Examples of the aromatic dicarboxylic acid or the chloride of an aromatic dicarboxylic acid include phthalic acid, isophthalic acid, terephthalic acid, 4,4'-biphenyl dicarboxylic acid, diphenoxyethanedicarboxylic acid, diphenyl ether 4,4'-dicarboxylic acid, 4,4'-diphenyl sulfone dicarboxylic acid, 1,5-naphthalenedicarboxylic acid, and 2,6-naphthalenedicarboxylic acid, as well as chlorides of these compounds. Further, the polyarylate resin to be used may be a modified polyarylate resin. Of these, the polyarylate resin is preferably one made from a polymer compound obtained by the reaction between 2,2-bis(4'-hydroxyphenyl)propane and isophthalic acid.

The polymer component (A) can be used alone, or in a combination of two or more. In addition, a polymer component (A') having Tg of 250°C or higher and a polymer component (A") having Tg of lower than 250°C may be used in combination as the polymer components (A). Examples of the polymer component (A") include a polyamide resin; and a polyarylate resin with a Tg lower than 250°C; and a polyamide resin is preferred.

The polyamide resin is preferably soluble in an organic solvent, preferably a rubber-modified polyamide resin. Examples of the rubber-modified polyamide resin that can be used include one described in JP 2004-035638 A.

From the viewpoint that elongation properties can be adjusted and from the viewpoint of solvent resistance, the polymer component (A) and the polymer component (A") are preferably a component formed using a single type of polyimide resin, a component formed using a plurality of different types of polyimide resins, and a component formed by adding at least one of a polyamide resin or a polyarylate resin to the polyimide resin.

When adding a polyamide resin or a polyarylate resin with a Tg lower than 250°C, to a polyimide resin, the amount of resin to be added is preferably 100 parts by mass or less, more preferably 70 parts by mass or less, even more preferably 50 parts by mass or less, and further even more preferably 30 parts by mass or less, and preferably 1 part by mass or greater, more preferably 3 parts by mass or greater, per 100 parts by mass of the polyimide resin, from the viewpoint of imparting appropriate flexibility while maintaining a high Tg.

Curable monomer (B)

The curable monomer (B) is a monomer having a polymerizable unsaturated bond and is a monomer that can participate in a polymerization reaction or a polymerization reaction. Using the curable monomer (B), drying efficiency is improved when the cured resin layer is formed by coating and drying, and the cured resin layer is easily peeled off from the casting film. Furthermore, an optical film excellent in the solvent resistance can be obtained.

The cured resin layer is a layer composed of a cured product of the curable resin composition containing the polymer component (A) and the curable monomer (B) described above, and this facilitates the formation of the thin cured resin layer with excellent heat resistance. In addition, when such a material is used, there is no optical problem caused by materials having anisotropic molecular orientation, such as polyester films that are commonly used as substrates for optical films.

The molecular weight of the curable monomer (B) is usually 3000 or less, preferably from 200 to 2000, and more preferably from 200 to 1000. The curable monomer (B) with a molecular weight in such a range can more efficiently prevent a skinning phenomenon described later when the coating of the curable resin composition is formed.

Examples of the curable monomer (B) include a monofunctional (meth)acrylic acid derivative and a polyfunctional (meth)acrylic acid derivative. It is preferably a polyfunctional (meth)acrylic acid derivative from the viewpoint that a cured resin layer having even better heat resistance and solvent resistance is obtained. The polyfunctional (meth)acrylic acid derivative is preferably a bifunctional (meth)acrylic acid derivative from the viewpoint that it is easily mixed with the polymer component (A) and that curing shrinkage of the polymer is unlikely to occur and curling of the cured product can be suppressed.

The monofunctional (meth)acrylic acid derivative is not particularly limited, and a known compound can be used. Examples of the monofunctional (meth)acrylic acid derivative include a monofunctional (meth)acrylic acid derivative having a nitrogen atom, a monofunctional (meth)acrylic acid derivative having an alicyclic structure, and a monofunctional (meth)acrylic acid derivative having a polyether structure.

Examples of the monofunctional (meth)acrylic acid derivative having a nitrogen atom include a compound represented by the following formula.

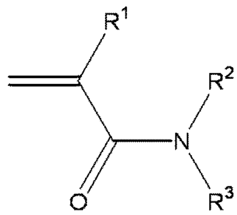

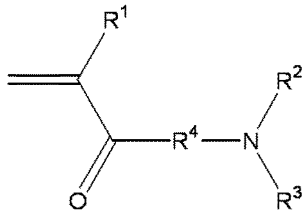

where $R^1$ represents a hydrogen atom or an alkyl group having from 1 to 6 carbons; $R^2$ and $R^3$ each independently represent a hydrogen atom or an organic group having from 1 to 12 carbons, and $R^2$ and $R^3$ may bond to form a ring structure; and $R^4$ represents a divalent organic group.

Examples of the alkyl group having from 1 to 6 carbons represented by $R^1$ include a methyl group, an ethyl group, and a propyl group, of which a methyl group is preferable.

Examples of the organic group having from 1 to 12 carbons represented by $R^2$ and $R^3$ include: an alkyl group having from 1 to 12 carbons, such as a methyl group, an ethyl group, and a propyl group; a cycloalkyl group having from 3 to 12 carbons, such as a cyclopentyl group and a cyclohexyl group; and an aromatic group having from 6 to 12 carbons, such as a phenyl group, a biphenyl group, and a naphthyl group. These groups may have a substituent at any position. Additionally, $R^2$ and $R^3$ may bond together to form a ring, and the ring may further contain a nitrogen atom or an oxygen atom in the skeleton.

Examples of the divalent organic group represented by $R^4$ include groups represented by $-(CH_2)_m-$ and $-NH-(CH_2)_m-$. Here, m is an integer of from 1 to 10.

Among these, a preferred example of the monofunctional (meth)acrylic acid derivative having a nitrogen atom is a (meth)acryloyl morpholine represented by the following formula.

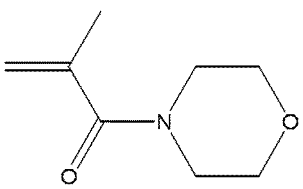

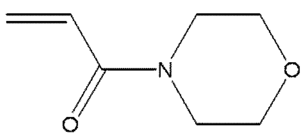

Using a monofunctional (meth)acrylic acid derivative having a nitrogen atom as the curable monomer (B) can form a cured resin layer with even better heat resistance.

Examples of the monofunctional (meth)acrylic acid derivative having an alicyclic structure include a compound represented by the following formula.

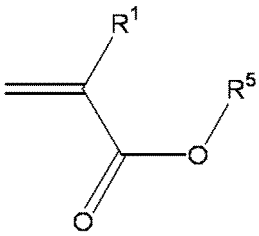

where $R^1$ represents the same as described above, and $R^5$ represents a group having an alicyclic structure.

Examples of the group having an alicyclic structure represented by $R^5$ include a cyclohexyl group, an isobornyl group, a 1-adamantyl group, a 2-adamantyl group, and a tricyclodecanyl group.

Specific examples of the monofunctional (meth)acrylic acid derivative having an alicyclic structure include isobornyl(meth)acrylate, cyclohexyl(meth)acrylate, 1-adamantyl(meth)acrylate, and 2-adamantyl(meth)acrylate.

Using a monofunctional (meth)acrylic acid derivative having an alicyclic structure as the curable monomer (B) can form a cured resin layer with even better optical properties.

Examples of the monofunctional (meth)acrylic acid derivative having a polyether structure include a compound represented by the following formula.

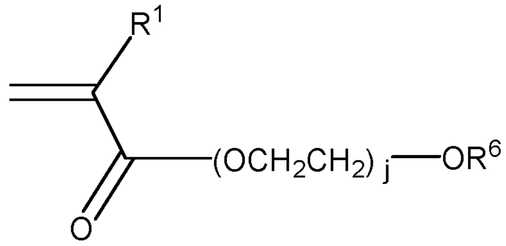

where $R^1$ represents the same as described above, and $R^6$ represents an organic group having from 1 to 12 carbons. Examples of the organic group having from 1 to 12 carbons represented by $R^6$ include: an alkyl group having from 1 to 12 carbons, such as a methyl group, an ethyl group, and a propyl group; a cycloalkyl group having from 3 to 12 carbons, such as a cyclohexyl group; and an aromatic group having from 6 to 12 carbons, such as a phenyl group, a biphenyl group, and a naphthyl group. j represents an integer of from 2 to 20.

Specific examples of the monofunctional (meth)acrylic acid derivative having a polyether structure include ethoxylated o-phenylphenol(meth)acrylate, methoxypolyethylene glycol (meth)acrylate, and phenoxypolyethylene glycol (meth)acrylate.

Using a monofunctional (meth)acrylic acid derivative having a polyether structure as the curable monomer (B) can form a cured resin layer with excellent toughness.

The polyfunctional (meth)acrylic acid derivative is not particularly limited, and a known compound can be used. Examples thereof include 2 to 6 functional (meth)acrylic acid derivatives, and bifunctional (meth)acrylic acid derivatives are preferable as described above.

Examples of the bifunctional (meth)acrylic acid derivative include a compound represented by the following formula.

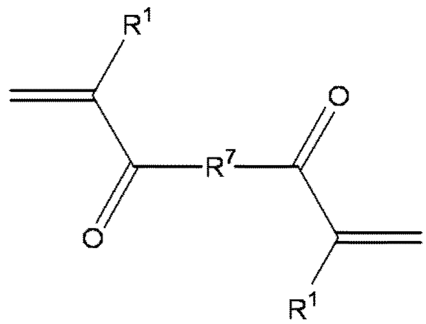

where $R^1$ represents the same as described above, and $R^7$ represents a divalent organic group. Examples of the divalent organic group represented by $R^7$ include a group represented by the following formula.

$-O-(CH_2)_s-O-$

$-O(CH_2CH_2O)_t-$

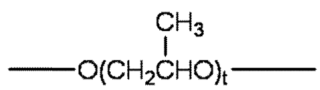

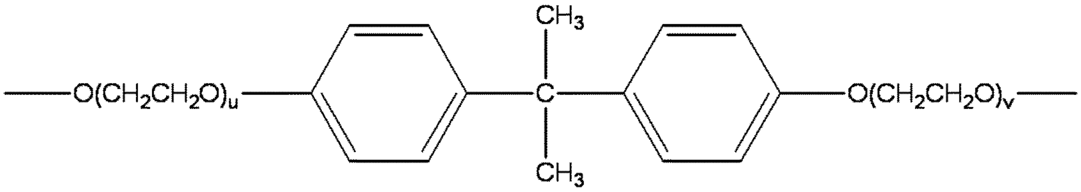

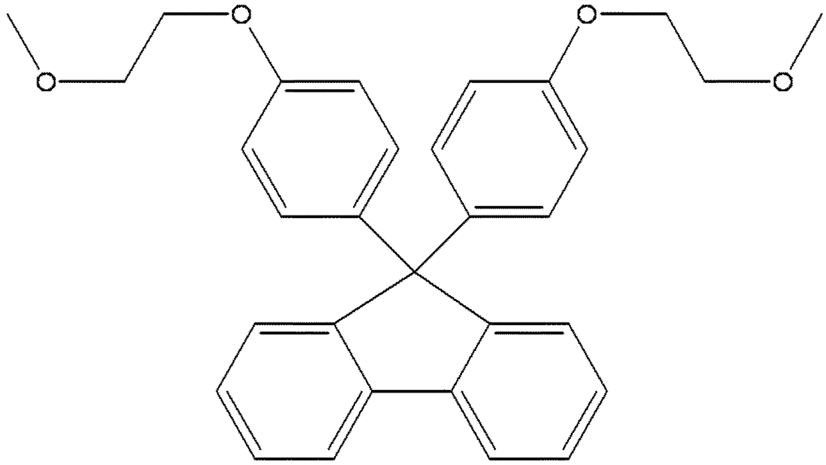

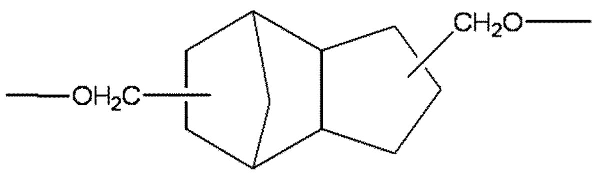

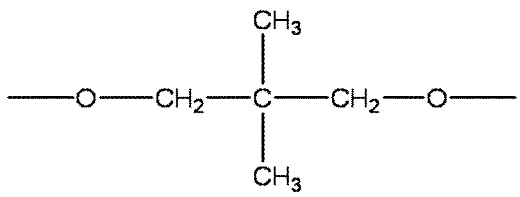

where s represents an integer of from 1 to 20, t represents an integer of from 1 to 30, u and v each independently represent an integer of from 1 to 30, and the "-" at both ends represents a bond.

Specific examples of the bifunctional (meth)acrylic acid derivative represented by the formula above include: tricyclodecane dimethanol di(meth)acrylate, polyethylene glycol di(meth)acrylate, propoxylated ethoxylated bisphenol A di(meth)acrylate, ethoxylated bisphenol A di(meth)acrylate, 1,10-decanediol di(meth)acrylate, 1,6-hexanediol di(meth)acrylate, and 9,9-bis[4-(2-acryloyloxyethoxy)phenyl]fluorene. Among these, the followings are preferred from the viewpoints of heat resistance and toughness: a bifunctional (meth)acrylic acid derivative represented by the formula above where the divalent organic group represented by $R^7$ has a tricyclodecane skeleton, such as tricyclodecane dimethanol di(meth)acrylate; a bifunctional (meth)acrylic acid derivative represented by the formula above where the divalent organic group represented by $R^7$ has a bisphenol skeleton, such as propoxylated ethoxylated bisphenol A di(meth)acrylate and ethoxylated bisphenol A di(meth)acrylate; and a bifunctional (meth)acrylic acid derivative represented by the formula above where the divalent organic group represented by $R^7$ has a 9,9-bisphenylfluorene skeleton, such as 9,9-bis[4-(2-acryloyloxyethoxy)phenyl]fluorene.

Additional examples of the bifunctional (meth)acrylic acid derivative include neopentyl glycol adipate di(meth)acrylate, hydroxypivalic acid neopentyl glycol di(meth)acrylate, caprolactone-modified dicyclopentenyl di(meth)acrylate, ethylene oxide-modified phosphoric acid di(meth)acrylate, di(acryloxyethyl)isocyanurate, and allylated cyclohexyl di(meth)acrylate.

Examples of the trifunctional (meth)acrylic acid derivative include trimethylolpropane tri(meth)acrylate, pentaerythritol tri(meth)acrylate, propionic acid-modified dipentaerythritol tri(meth)acrylate, propylene oxide-modified trimethylolpropane tri(meth)acrylate, and tris(acryloxyethyl)isocyanurate.

Examples of the tetrafunctional (meth)acrylic acid derivative include pentaerythritol tetra(meth)acrylate.

Examples of the pentafunctional (meth)acrylic acid derivative include propionic acid-modified dipentaerythritol penta(meth)acrylate.

Examples of the hexafunctional (meth)acrylic acid derivative include dipentaerythritol hexa(meth)acrylate and caprolactone-modified dipentaerythritol hexa(meth)acrylate.

A cyclopolymerization monomer may also be used as the curable monomer (B). A cyclopolymerization monomer is a monomer having the property of undergoing cyclization and radical polymerization at the same time. Examples of the cyclopolymerization monomer include a non-conjugated diene, such as $\alpha$-allyloxymethylacrylic acid-based monomers, preferably an alkyl ester having from 1 to 4 carbons of 2-allyloxymethyl acrylic acid and cyclohexyl 2-allyloxymethyl acrylate, more preferably an alkyl ester having from 1 to 4 carbons of 2-allyloxymethyl acrylic acid, and even more preferably methyl 2-(allyloxymethyl) acrylate.

Additional examples of the cyclopolymerization monomer that can be used include dimethyl-2,2'-[oxybis(methylene)]bis-2-propenoate, diethyl-2,2'-[oxybis(methylene)]bis-2-propenoate, di(n-propyl)-2,2'-[oxybis(methylene)]bis-2-propenoate, di(i-propyl)-2,2'-[oxybis(methylene)]bis-2-propenoate, di(n-butyl)-2,2'-[oxybis(methylene)]bis-2-propenoate, di(n-hexyl)-2,2'-[oxybis(methylene)]bis-2-propenoate, and dicyclohexyl-2,2'-[oxybis(methylene)]bis-2-propenoate.

One curable monomer (B) can be used alone or two or more in combination.

The curable monomer (B) more preferably contains a polyfunctional (meth)acrylic acid derivative and a cyclopolymerization monomer. The combined use of these appropriately adjusts the heat resistance of the cured resin layer and makes it easier to adjust the elongation at break of the cured resin layer to a predetermined range.

When the curable monomer (B) contains a polyfunctional (meth)acrylic acid derivative, the content of the polyfunctional (meth)acrylic acid derivative is preferably 40 mass% or greater, more preferably from 50 to 100 mass%, of the total mass of the curable monomer (B).

Curable resin composition

The curable resin composition that is used to form the cured resin layer according to an embodiment of the present invention can be prepared by mixing the polymer component (A), the curable monomer (B), and if desired a polymerization initiator or another component described later, and dissolving or dispersing the mixture in a suitable solvent.

A total content of the polymer component (A) and the curable monomer (B) in the curable resin composition is preferably from 40 to 99.5 mass%, more preferably from 60 to 99 mass%, and even more preferably from 80 to 98 mass% relative to the total mass of the curable resin composition excluding the solvent.

The content of the polymer component (A) and the curable monomer (B) in the curable resin composition is, in terms of a mass ratio of the polymer component (A) to the curable monomer (B), preferably from 30:70 to 90: 10, and more preferably from 35:65 to 80:20.

The curable resin composition with a mass ratio of the polymer component (A) to the curable monomer (B) in such a range tends to further improve the flexibility of the resulting cured resin layer and maintain the solvent resistance of the cured resin layer and the peelability from the casting film.

Furthermore, when the content of the curable monomer (B) in the curable resin composition is within the ranges described above, the solvent can be efficiently removed when the cured resin layer is formed by, for example, a solution casting method. As a result, deformation such as curling and waviness due to the prolonged time of the drying step is eliminated.

When a plurality of resins having different solvent solubility are used in combination as the polymer component (A), such as a combination of a polyimide resin and a polyamide resin or a polyarylate resin described above, it is preferable to first dissolve the resins in their corresponding suitable solvents separately, and then add a solution, in which one resin is dissolved, to an organic solvent having a low boiling point, in which another resin is dissolved.

The curable resin composition can optionally contain a polymerization initiator. The polymerization initiator is not particularly limited as long as it is one that initiates a curing reaction. Examples of the polymerization initiator include a photopolymerization initiator.

Examples of the photopolymerization initiator include: alkylphenone-based photopolymerization initiators, such as 2,2-dimethoxy-1,2-diphenylethan-1-one, 1-hydroxy-cyclohexyl-phenyl ketone, 2-hydroxy-2-methyl-1-phenyl-propan-1-one, 1-[4-(2-hydroxyethoxy)-phenyl]-2-hydroxy-2-methyl-1-propan-1-one, 2-hydroxy-1-[4-[4-(2-hydroxy-2-methyl-propionyl)-benzyl]phenyl]-2-methyl-propan-1-one, 2-methyl-1-(4-methylthiophenyl)-2-morpholinopropane-1-one, 2-benzyl-2-dimethylamino-1-(4-morpholinophenyl)-butanone-1, and 2-(dimethylamino)-2-[(4-methylphenyl)methyl]-1-[4-(4-morpholinyl)phenyl]-1-butanone; phosphorus-based photopolymerization initiators, such as 2,4,6-trimethylbenzoyl-diphenylphosphineoxide, bis(2,4,6-trimethylbenzoyl)-phenylphosphineoxide, ethyl(2,4,6-trimethylbenzoyl)-phenylphosphinate, and bis(2,6-dimethoxybenzoyl)-2,4,4-trimethyl-pentylphosphine oxide; titanocene-based photopolymerization initiators, such as bis($\eta^5$-2,4-cyclopentadiene-1-yl)-bis[2,6-difluoro-3-(1H-pyrrol-1-yl)-phenyl] titanium; oxime ester-based photopolymerization initiators, such as 1,2-octanedione-1-[4-(phenylthio)-2-(O-benzoyloxyme)] and ethanone-1-[9-ethyl-6-(2-methylbenzoyl)-9H-carbazole-3-yl]-1-(O-acetyloxyme); benzophenone-based photopolymerization initiators, such as benzophenone, p-chlorobenzophenone, benzoylbenzoic acid, methyl o-benzoylbenzoate, 4-methylbenzophenone, 4-phenylbenzophenone, hydroxybenzophenone, acrylated benzophenone, 4-benzoyl-4'-methyl-diphenyl sulfide, 3,3'-dimethyl-4-methoxybenzophenone, 2,4,6-trimethylbenzophenone, and 4-(13-acryloyl-1,4,7,10,13-pentaoxatridecyl)-benzophenone; and thioxanthone-based photopolymerization initiators, such as thioxanthone, 2-chlorothioxanthone, 3-methylthioxanthone, 2,4-dimethylthioxanthone, 2,4-diisopropylthioxanthone, 2,4-dichlorothioxanthone, 1-chloro-4-propoxythioxanthone, 2-methylthioxanthone, 2-isopropylthioxanthone, and 4-isopropylthioxanthone.

Among the photopolymerization initiators described above, phosphorus-based photopolymerization initiators, such as 2,4,6-trimethylbenzoyl-diphenylphosphineoxide, bis(2,4,6-trimethylbenzoyl)-phenylphosphineoxide, ethyl(2,4,6-trimethylbenzoyl)-phenylphosphinate, and bis(2,6-dimethoxybenzoyl)-2,4,4-trimethyl-pentylphosphine oxide, are preferred.

When the polymer component (A) is a thermoplastic resin having an aromatic ring, the polymer component (A) absorbs ultraviolet light and, as a result, curing reaction may be difficult to occur. However, using a phosphorous-based photopolymerization initiator described above facilitates efficient curing reaction by utilizing light having a wavelength that is not absorbed by the polymer component (A).

The polymerization initiator can be used alone or in a combination of two or more.

The content of the polymerization initiator is preferably from 0.05 to 15 mass%, more preferably from 0.05 to 10 mass%, and even more preferably from 0.05 to 5 mass% relative to the total amount of the curable resin composition.

In addition to the polymer component (A), the curable monomer (B), and the polymerization initiator, the curable resin composition may also contain a photopolymerization initiator aid, such as triisopropanolamine and 4,4'-diethylaminobenzophenone.

The solvent used to prepare the curable resin composition is not particularly limited, and examples include: aliphatic hydrocarbon solvents, such as n-hexane and n-heptane; aromatic hydrocarbon solvents, such as toluene and xylene; halogenated hydrocarbon solvents, such as dichloromethane, ethylene chloride, chloroform, carbon tetrachloride, 1,2-dichloroethane, and monochlorobenzene; alcohol-based solvents, such as methanol, ethanol, propanol, butanol, and propylene glycol monomethyl ether; ketone solvents, such as acetone, methyl ethyl ketone, 2-pentanone, isophorone, and cyclohexanone; ester-based solvents, such as ethyl acetate and butyl acetate; cellosolve solvents, such as ethyl cellosolve; and ether-based solvents, such as 1,3-dioxolane.

The content of the solvent in the curable resin composition is not particularly limited, but is usually from 0.1 to 1000 g, preferably from 1 to 100 g, per g of the polymer component (A). As the amount of the solvent is adjusted appropriately, the viscosity of the curable resin composition can be adjusted to an appropriate value.

Furthermore, the curable resin composition may further contain a known additive such as a plasticizer, an antioxidant, and an ultraviolet absorber, within a range that does not impair the object and effect of the present invention.

The method of curing the curable resin composition can be determined according to the polymerization initiator or curable monomer used. The details will be described in the section of an optical film manufacturing method described later.

Properties of cured resin layer, etc.

As described above, in the cured resin layer, one or more loss tangent peaks are present in a curve representing a change in loss tangent with respect to temperature change, obtained in dynamic viscoelasticity measurement of a heating rate of 3°C/sec from 25°C to 280°C, and peak temperatures of all loss tangent peaks are 150°C or higher. As described above, the cured resin layer of the optical film according to an embodiment of the present invention has a storage modulus reduction rate of 40% or less. The cured resin layer has the following properties and the like in addition to these properties.

A thickness of the cured resin layer is preferably 20 μm or less, more preferably 15 μm or less, still more preferably 12 μm or less, and even more preferably 10 μm or less. The lower limit of the thickness of the cured resin layer is not particularly limited but is typically 0.1 μm or greater and preferably 0.2 μm or greater.

Note that when the cured resin layer includes a plurality of layers, the thickness of the cured resin layer is an overall thickness including a plurality of layers.

With the cured resin layer with a thickness of 20 μm or less, a thin and lightweight optical film can be readily produced and the optical film has excellent handling properties.

In addition, the cured resin layer is thin, and thus this can provide a transparent conductive film and a gas barrier film having high transparency as well as being thin and light weight. Thus, in applications where thinner devices are required, such as those in organic EL displays, the transparent conductive film will not be a factor that contributes

the increase in the overall thickness of a device when the transparent conductive film and the gas barrier film is applied; thus, this is preferred. In addition, the thin transparent conductive film and the gas barrier film can improve the flexibility and bending resistance after the transparent conductive film and the gas barrier film are mounted.

The cured resin layer included in the optical film according to an embodiment of the present invention has a thermal deformation rate determined by a temperature increase to 150°C, in an absolute value, of preferably 1.2% or less, more preferably 1.1% or less, and still more preferably 1.0% or less. When the cured resin layer has the thermal deformation rate determined by a temperature increase to 150°C within the above numerical range in an absolute value, the cured resin layer readily exhibits excellent heat resistance. This prevents deterioration of the performance of the transparent conductive layer or the performance of the gas barrier layer, which may be caused by deformation of the cured resin layer or the like due to heating during the formation of the transparent conductive layer by heating the conductive material layer or of the formation of the gas barrier layer .

In particular, since the cured resin layer has high heat resistance, it is possible to avoid difficulty in forming the transparent conductive layer and the gas barrier layer due to deformation of the cured resin layer even when the transparent conductive film and the gas barrier film are produced through a step involving heating after the formation of the cured resin layer, such as forming the conductive material layer on the cured resin layer by sputtering, vapor deposition, coating, or the like, further heating the conductive material layer to form the transparent conductive layer, or applying a coating liquid for forming a gas barrier layer to form the gas barrier layer. In addition, it is possible to avoid that the transparent conductive layer cannot exhibit sufficient electrical characteristics and the gas barrier layer cannot exhibit sufficient gas barrier properties. From a similar viewpoint, the absolute value of the thermal deformation rate of the cured resin layer by a temperature increase to 150°C is preferably 0.8% or lower.

The thermal deformation rate of the cured resin layer is a characteristic value measured by the following method. Note that the reason why the cured resin layer is measured by adjusting the thickness of the cured resin layer to 20 μm is to avoid the problem that the cured resin layer is elongated when the cured resin layer is attached to a jig of a thermomechanical analyzer.

Four cured resin layers obtained by peeling off and removing the casting film are laminated to form a laminate having a thickness of 20 μm. Then, the laminate is cut into a 5 mm × 30 mm test piece, and the test piece of the laminate of the cured resin layer is held in a thermomechanical analyzer (TMA4000SE, available from NETZSCH Japan K. K.) with a distance between chucks set at 20 mm. The laminate of the cured resin layer is then subjected to a temperature increase from 25°C to 150°C at 5°C/min and then cooled to 25°C at 5°C/min. Then, the rate of change of displacement (a value expressed in percentages of displacement amount relative to the distance between chucks of 20 mm) in the longitudinal direction before and after heating is defined as the thermal deformation rate of the cured resin layer. The value is negative when the laminate of the cured resin layer shrinks and positive when the laminate of the cured resin layer elongates.

The cured resin layer also has excellent solvent resistance. Because of this excellent solvent resistance, the cured resin layer surface hardly dissolves, for example, even when an organic solvent is used in formation of another layer on the cured resin layer surface. Therefore, for example, even when the transparent conductive layer is formed on the surface of the cured resin layer by a coating method using a resin solution containing an organic solvent, or even when the gas barrier layer is formed using a coating liquid of a polysilazane-based gas barrier layer, a component of the cured resin layer is less likely to be mixed into the transparent conductive layer or the gas barrier layer. Therefore, the electrical characteristics of the transparent conductive layer and the gas barrier property of the gas barrier layer are hardly deteriorated.

From such a viewpoint, the gel fraction of the cured resin layer is preferably 94% or greater and more preferably 97% or greater. In the cured resin layer having a gel fraction of 94% or greater, the residual amount of the curable monomer (B) after curing is small, and a cured resin layer satisfying the requirement (I) described above is easily obtained.

Here, the gel fraction is determined as follows: a cured resin layer cut to 100 mm × 100 mm is wrapped with a 150 mm × 150 mm nylon mesh (#120) whose mass has been measured in advance; this piece is immersed in toluene (100 mL) for 3 days, removed from toluene, and dried at 120°C for 1 hour; the piece is then allowed to stand under conditions of 23°C and a relative humidity of 50% for 3 hours for conditioning, the mass is measured, and then the gel fraction is calculated by Equation (2) below.

$$\text{Gel fraction (\%)} = [(\text{mass of remaining resin after immersion})/(\text{mass of resin before immersion})] \times 100 \quad \ldots \quad \text{Equation (2)}$$

The cured resin layer is excellent in interlayer adhesion with a functional layer such as a transparent conductive layer or a gas barrier layer. That is, a functional layer such as a transparent conductive layer or a gas barrier layer can

be formed without an anchor coat layer provided on the cured resin layer.

The cured resin layer is preferably colorless and transparent. The cured resin layer is colorless and transparent, and thus the optical film according to an embodiment of the present invention can be preferably used in optical applications. Specifically, the total light transmittance of the optical film according to the embodiment of the present invention is preferably 85% or greater, more preferably 90% or greater. The total light transmittance is a characteristic value measured by the method described in examples.

The cured resin layer has a low birefringence and excellent optical isotropy. The in-plane phase difference of the cured resin layer is typically 20 nm or less and preferably 15 nm or less. The phase difference in the thickness direction is typically - 500 nm or less and preferably -450 nm or less. In addition, the value (birefringence) obtained by dividing the in-plane phase difference by the thickness of the cured resin layer is typically $100 \times 10^{-5}$ or lower and preferably $20 \times 10^{-5}$ or lower.

When the cured resin layer with an in-plane phase difference, a phase difference in the thickness direction, and a birefringence in the above range, an optical film having low birefringence and excellent optical isotropy can be obtained, and a transparent conductive film and the gas barrier film produced using this optical film can be preferably used in optical applications.

The elongation at break of the cured resin layer is preferably 2.5% or higher, more preferably 2.6% or higher, and even more preferably 2.7% or higher. When an elongation at break of the cured resin layer is 2.5% or higher, the elongation at break of the optical film can be easily adjusted to approximately 2% or higher and consequently, an optical film excellent in the flexibility can be readily obtained. The elongation at break can be measured in accordance with JIS K 7127:1999.

1-2. Casting film

The casting film has a role of protecting the cured resin layer and optional another layer provided when the optical film or the transparent conductive film and the gas barrier film as described later are stored or transported. And the casting film is peeled off in a predetermined process.

The casting film has, for example, a substrate layer. The casting film may be provided with a layer other than the substrate layer, or may be provided with a release layer as another layer. Since the cured resin layer is a cured product of the curable resin composition containing the curable monomer (B), the cured resin layer is easily peeled from the casting film even if the casting film is not provided with a release layer.

The optical film has a casting film, and thus this protects the cured resin layer and can form the optical film with high handling properties. The optical film may have the casting film on one surface of the cured resin layer as illustrated in Fig. 1(a) or may have casting films on both surfaces of the cured resin layer as illustrated in Fig. 1(b). In the latter case, it is preferable to use two types of casting films so that the casting film to be peeled first is more easily peeled than the other casting film.

The casting film is preferably in the shape of a sheet or a film. Here, the shape of a sheet or a film is not limited to an elongated shape and also includes the shape of a short flat plate.

Examples of the substrate layer of the casting film include paper substrates, such as glassine paper, coat paper, and wood-free paper; laminated paper in which a thermoplastic resin, such as polyethylene or polypropylene, is laminated on a paper substrate of those described above; those formed by sealing a paper substrate of those described above with, for example, cellulose, starch, poly(vinyl alcohol), or an acrylic-styrene resin; plastic films, such as polyester films (such as poly(ethylene terephthalate), poly(butylene terephthalate), and poly(ethylene naphthalate)) and polyolefin films (such as polyethylene and polypropylene); and glass.

The release layer can be formed using a known release agent, such as a silicone-based release agent, a fluorine-based release agent, an alkyd-based release agent, and an olefin-based release agent.

The thickness of the release layer is not particularly limited but is typically from 0.02 to 2.0 $\mu$m and more preferably from 0.05 to 1.5 $\mu$m.

From the viewpoint of ease of handling, the thickness of the casting film is preferably 1 to 500 $\mu$m and more preferably from 5 to 300 $\mu$m.

An average surface roughness (arithmetic average roughness Ra) of the surface of the casting film on which the cured resin layer is provided is preferably 10 nm or less, more preferably 8.0 nm or less, and still more preferably 5.0 nm or less. Furthermore, a maximum surface roughness (maximum sectional height Rt) of the surface of a substrate layer of the casting film on which the cured resin layer is provided is preferably 100 nm or less, more preferably 70 nm or less, and still more preferably 50 nm or less. A lower limit of the average surface roughness and the maximum surface roughness is not particularly limited, and the average surface roughness is usually 0.3 nm or greater, and the maximum surface roughness is 10 nm or greater.

When the average surface roughness of the substrate layer surface of the casting film on which the cured resin layer is provided is 10 nm or less and the maximum surface roughness is 100 nm or less, an increase in haze of the

cured resin layer can be suppressed.

In the present specification, the "maximum surface roughness" means the maximum profile peak height Rt, and the "average surface roughness" means the arithmetic average roughness Ra. Both are obtained by optical interferometry at a measurement area of 100 μm × 100 μm.

1-3. Another layer

The casting film may include a layer such as a primer layer or an antistatic layer, besides the release layer.

Of the layers constituting the optical film, a portion (separation layer) to be peeled off from the casting film in a predetermined process includes the cured resin layer. The cured resin layer is laminated on the casting film without interposition of another layer, and thus the cured resin layer is located on one outermost surface of the separation layer. On the other surface side of the separation layer, a layer besides the cured resin layer, such as a primer layer or an antistatic layer, may be provided, but the separation layer is preferably thin because it is a layer constituting the transparent conductive film and the gas barrier film after the removal of the casting film, and thus it is preferable to minimize the number of the layers and thickness of the layers other than the cured resin layer.

2. Transparent conductive film

The transparent conductive film according to an embodiment of the present invention includes a transparent conductive layer on a cured resin layer of the optical film. In other words, the transparent conductive film includes the casting film, the cured resin layer, and the transparent conductive layer in this order. In the actual use of the transparent conductive film, the casting film is peeled off from the transparent conductive film, and the transparent conductive film is used by incorporating into a display or a solar panel or by attaching to a substrate of a touch sensor for a touch panel. For the method of applying the transparent conductive film to the portion to which the transparent conductive film is to be applied, for example, when the transparent conductive film has an adhesive layer as described later, the transparent conductive film is attached with the adhesive layer to the portion to which the transparent conductive film is to be applied, and after the application, the casting film is peeled off.

A specific example of a configuration of the transparent conductive film according to an embodiment of the present invention is illustrated in Figs. 2(a) and 2(b).

A transparent conductive film 20 illustrated in Fig. 2(a) has a transparent conductive layer 3 on one surface of the cured resin layer 2 and has the casting film 1 on a surface of the cured resin layer 2, the surface opposite from the transparent conductive layer 3.

The transparent conductive layer 3 is formed, for example, to cover the entire surface of the cured resin layer 2. In addition, the transparent conductive layer 3 can be patterned into a desired shape by an appropriate method, such as etching. A transparent conductive film 21 illustrated in Fig. 2(b) has a pattern-formed transparent conductive layer 31 on one surface of the cured resin layer 2. A transparent conductive material may be placed on the cured resin layer 2 selectively, and thus, without going through a process, such as etching, the transparent conductive layer 31 having a desired pattern shape may be formed on the cured resin layer 2.

Peeling off the casting film 1 from the transparent conductive film in the state illustrated in Figs. 2(a) and 2(b) tends to make handling properties poor. Thus, the casting film 1 is preferably peeled off and removed after the transparent conductive film is applied to a portion of an adherend or the like, the portion to which the transparent conductive film is to be applied.

The thickness of the transparent conductive film can be appropriately determined according to the target application or the like. The substantial thickness of the transparent conductive film according to an embodiment of the present invention is, from the viewpoint of handling properties, preferably from 0.3 to 50 μm, more preferably from 0.5 to 25 μm, and more preferably from 0.7 to 12 μm.

The "substantial thickness" refers to the thickness in a use state. That is, the transparent conductive film has the casting film, but the thickness of the portion (such as the casting film) to be removed in use is not included in the "substantial thickness".

In the present specification, "transparent" in the transparent conductive film means that the light transmittance at a wavelength of 450 nm is 80% or higher.

Examples of the conductive material constituting the transparent conductive layer include a metal, an alloy, a metal oxide, an electrically conductive compound, and a mixture of these. Specific examples include: antimony-doped tin oxide (ATO); fluorine-doped tin oxide (FTO); a semi-conductive metal oxide, such as tin oxide, germanium-doped zinc oxide (GZO), zinc oxide, indium oxide, indium tin oxide (ITO), and indium zinc oxide (IZO); a metal such as gold, silver, chromium, and nickel; a mixture of these metals and conductive metal oxides; an inorganic conductive substance such as copper iodide and copper sulfide; and an organic conductive material such as polyaniline, polythiophene, and polypyrrole. The metal, such as silver, may constitute a transparent conductive layer by aggregation of the metal in the

particulate state, such as nanofiller, nanorod, or nanofiber.

The method of forming the transparent conductive layer is not particularly limited. Examples include vapor deposition, sputtering, ion plating, thermal CVD, and plasma CVD.

In addition, the transparent conductive layer may be formed from a coating, for example, by applying a coating material containing a metal in the particulate form to the optical film. More specifically, it is preferable to form the transparent conductive layer by: forming the conductive material layer by the PVD method or the CVD method as described above, or by applying and drying the coating material; and further heating the conductive material layer to 140°C or higher using an electric furnace or the like to crystallize the conductive material.

When a cured resin layer having low heat resistance is used, the cured resin layer may be deformed by heating during vapor deposition, sputtering, or performing a heat treatment after coating. The deformation of the cured resin layer can adversely affect the conductivity of the transparent conductive layer of the transparent conductive film. However, since the cured resin layer of the transparent conductive film according to the embodiment of the present invention is excellent in heat resistance, deformation hardly occurs even by heating in such a step. Therefore, a decrease in conductivity of the transparent conductive film due to deformation of the cured resin layer can also be avoided.

After formation of the transparent conductive film, the adhesive layer may be provided on the transparent conductive layer.

The thickness of the transparent conductive layer is appropriately selected according to the application or the like. The thickness of the transparent conductive layer is typically from 10 nm to 50 $\mu$m and preferably from 20 nm to 20 $\mu$m.

The transparent conductive film according to an embodiment of the present invention is not limited to the transparent conductive film having the configuration illustrated in Figs. 2(a) and 2(b) and may further contain one or two or more other layers in a range that does not impair the object of the present invention.

Examples of the other layers include an adhesive layer, a shock absorbing layer, a hard coat layer, and a refractive index adjusting layer (index/matching layer). The position of another layer to be placed is not particularly limited.

The adhesive layer is a layer to be used when the transparent conductive film is attached to an adherend. The material for forming the adhesive layer is not particularly limited, and a known adhesive or pressure-sensitive adhesive, such as an acrylic-based adhesive or pressure-sensitive adhesive, a silicone-based adhesive or pressure-sensitive adhesive, and a rubber-based adhesive or pressure-sensitive adhesive, and a heat sealing material can be used. For the transparent conductive film in which the adhesive layer is formed on the opposite side of the cured resin layer, the side opposite from the surface facing the casting film, a thin coating having the cured resin layer and the transparent conductive layer can be easily formed on an adherend by attaching the transparent conductive film to the adherend by the adhesive layer, and then peeling off the casting film. In the transparent conductive film according to an embodiment of the present invention, the casting film is flexible, and thus this facilitates such an attachment and peeling off of the casting film. The transparent conductive film may have a release film for protecting the adhesive layer on the opposite side of the adhesive layer, the side opposite from the side facing the cured resin layer. When this configuration is adopted, the transparent conductive film has the casting films and the release films on the outermost layers on both sides and thus to be easily handled.

3. Gas barrier film

The gas barrier film includes a gas barrier layer and a cured resin layer. The gas barrier film includes the casting film, the cured resin layer, and the gas barrier layer in this order. The gas barrier film may include two or more gas barrier layers.

A specific example of a configuration of the gas barrier film according to an embodiment of the present invention is illustrated in Fig. 2(c).

A gas barrier film 22 illustrated in Fig. 2(c) has a gas barrier layer 4 on one surface of the cured resin layer 2 and has a casting film 1 on a surface of the cured resin layer 2, the surface opposite from the gas barrier layer 4.

Peeling off the casting film 1 from the gas barrier film 22 in the state illustrated in Fig. 2(c) tends to make handling properties poor. Thus, the casting film 1 is preferably peeled off and removed after the gas barrier film 22 is applied to a portion of an adherend or the like, the portion to which the transparent conductive film is to be applied.

The gas barrier layer and the cured resin layer may be directly laminated, or may be laminated with another layer interposed therebetween. Examples of other layers included in the gas barrier film include an adhesive layer and an impact absorbing layer.

A plurality of sets of the cured resin layer and the gas barrier layer may be laminated. Another layer may be present between at least one set of the cured resin layers and the gas barrier layer of the plurality of sets in this case.

The water vapor transmission rate of the gas barrier film in an atmosphere of 40°C and 90% relative humidity is typically $1.0 \times 10^{-2}$ g/m$^2$/day or less, preferably $8.0 \times 10^{-3}$ g/m$^2$/day or less, and more preferably $6.0 \times 10^{-3}$ g/m$^2$/day or less.

The gas barrier layer of the gas barrier film according to an embodiment of the present invention is not limited

as long as the gas barrier layer has a gas barrier property. Examples include a gas barrier layer including an inorganic film, a gas barrier layer containing a gas barrier resin, and a gas barrier layer formed by modifying a layer containing a polymer compound.

Of these, the gas barrier layer is preferably a gas barrier layer including an inorganic film and a gas barrier layer formed by modifying a layer containing a polymer compound, from the perspective of capability to efficiently form a thin layer having excellent gas barrier property and solvent resistance.

The inorganic film is not limited, and examples include an inorganic vapor deposition film.

Examples of the inorganic vapor deposition film include an inorganic compound vapor deposition film or a metal vapor deposition film.

Examples of a raw material of the inorganic compound vapor deposition film include: inorganic oxides, such as silicon oxide, aluminum oxide, magnesium oxide, zinc oxide, indium oxide, and tin oxide; inorganic nitrides, such as silicon nitride, aluminum nitride; and titanium nitride; inorganic carbides; inorganic sulfides; inorganic oxynitrides, such as silicon oxynitride; inorganic oxycarbides; inorganic carbonitrides; and inorganic oxycarbonitrides.

Examples of a raw material of the metal vapor deposition film include aluminum, magnesium, zinc, and tin.

These raw materials can be used alone or in a combination of two or more.

A thickness of the inorganic vapor deposition film is typically in the range of approximately 10 to 2,000 nm.

Examples of the method for forming the inorganic vapor deposition film include a physical vapor deposition (PVD) method, such as vacuum deposition, sputtering, and ion plating, or a chemical vapor deposition (CVD) method, such as thermal CVD, plasma CVD, and optical CVD. When a cured resin layer having low heat resistance is used, the cured resin layer may be deformed by heating at the time of performing such vapor deposition or sputtering. Deformation of the cured resin layer can adversely affect the gas barrier property of the gas barrier layer of the gas barrier film. However, since the cured resin layer of the gas barrier film according to the embodiment of the present invention is excellent in heat resistance, deformation hardly occurs even by heating in such vapor deposition or sputtering. Therefore, the use of the cured resin layer can avoid deterioration of gas barrier property of the gas barrier film caused by deformation of the cured resin layer.

In the gas barrier layer formed by subjecting a layer (hereinafter, may be referred to as a "polymer layer") containing a polymer compound to a modification treatment, the polymer compound used is preferably a silicon-containing polymer compound. Examples of the silicon-containing polymer compound include a polysilazane-based compound, a polycarbosilane-based compound, a polysilane-based compound, and a polyorganosiloxane-based compound.

Of these, a polysilazane-based compound is preferable from the perspective of capability to form a gas barrier layer having excellent gas barrier property. Examples of the polysilazane-based compound include an inorganic polysilazane and an organic polysilazane. Examples of the inorganic polysilazane include perhydropolysilazane, and examples of the organic polysilazane include a compound in which some or all of the hydrogen in perhydropolysilazane is substituted with an organic group such as an alkyl group. Of these, an inorganic polysilazane is more preferable from the perspective of ease of access and being able to form a gas barrier layer having excellent gas barrier property.

Further, as the polysilazane compound, a commercially available product sold as a glass coating material or the like can be used as it is.

One type of the polysilazane compounds can be used alone or two or more types of the polysilazane compounds can be used in a combination.

In addition to the polymer compound described above, the polymer layer may contain another component within a range that does not inhibit the object of the present invention. Examples of the other component include a curing agent, another polymer, an anti-aging agent, a light stabilizer, and a flame retardant.

Examples of the method for forming the polymer layer include a method including: coating a layer-forming solution which contains at least one type of polymer compound, another component optionally, and a solvent on the resin layer or a primer layer optionally formed on the resin layer by using a spin coater, a knife coater, a gravure coater, or the like; and drying the obtained coating film as appropriate to form a polymer layer.

It is preferable to, for example, heat the coating film in order to dry the obtained coating film or to improve the gas barrier property of the gas barrier film. A known drying method such as hot air drying, hot roll drying, and infrared irradiation, can be used as the heating and drying method. The heating temperature is typically from 80 to 150°C, and the heating time is typically from tens of seconds to tens of minutes.

During the formation of the gas barrier layer of the gas barrier film, when, for example, a polysilazane-based compound as described above is used, a polysilazane conversion reaction occurs by heating after coating, resulting in a coating film having excellent gas barrier property.

Meanwhile, when a cured resin layer having low heat resistance is used, heating during the formation of such a coating film may result in deformation of the cured resin layer. Deformation of the cured resin layer can adversely affect the gas barrier property of the gas barrier layer of the gas barrier film. However, since the resin layer of the gas barrier film according to the embodiment of the present invention is excellent in heat resistance, deformation hardly occurs even by heating at the time of coating and after coating. Therefore, the use of the cured resin layer can avoid

deterioration of gas barrier property of the gas barrier film caused by deformation of the cured resin layer.

The thickness of the polymer layer is typically from 20 to 1000 nm, preferably from 30 to 800 nm, more preferably from 40 to 400 nm.

Even if the thickness of the polymer layer is in the order of nanometers, a gas barrier film having sufficient gas barrier performance can be obtained by performing a modification treatment as described below.

Examples of the modification treatment include ion implantation and vacuum ultraviolet light irradiation. Among these, ion implantation is preferable from the perspective of being able to obtain high gas barrier performance. In ion implantation, the dose of ions implanted into the polymer layer may be determined as appropriate according to the purpose of the gas barrier film to be formed (necessary gas barrier property, transparency, and the like).

Examples of the ions to be implanted include: ions of noble gases such as argon, helium, neon, krypton, and xenon; ions of fluorocarbon, hydrogen, nitrogen, oxygen, carbon dioxide, chlorine, fluorine, and sulfur; ions of alkane gases such as methane, ethane, propane, butane, pentane, and hexane; ions of alkene gases such as ethylene, propylene, butene, and pentene; ions of alkadiene gases such as pentadiene and butadiene; ions of alkyne gases such as acetylene and methyl acetylene; ions of aromatic hydrocarbon gases such as benzene, toluene, xylene, indene, naphthalene, and phenanthrene; ions of cycloalkane gases such as cyclopropane and cyclohexane; ions of cycloalkene gases such as cyclopentene and cyclohexene; ions of conductive metals such as gold, silver, copper, platinum, nickel, palladium, chromium, titanium, molybdenum, niobium, tantalum, tungsten, and aluminum; and ions of silane ($SiH_4$) or an organosilicon compound.

One type of these ions may be used alone or two or more types of the ions may be used in combination.

Of these, at least one species of ions selected from the group consisting of hydrogen, nitrogen, oxygen, argon, helium, neon, xenon, and krypton is preferable because of easier implantation and because a gas barrier layer having superior gas barrier property can be obtained.

The method of ion implantation is not limited, and examples include a method of irradiating ions (ion beam) accelerated by an electric field and a method of implanting plasma ions. Of these, the latter, a method of implanting plasma ions, is preferable because a film having gas barrier property can be easily obtained.

Examples of the ion species used in plasma ion implantation include the same as the ions exemplified as the ions to be implanted.

The thickness of the portion where ions are implanted can be controlled by implantation conditions, such as the species of ions, the applied voltage, and the processing time, and can be determined according to, for example, the thickness of the polymer layer and the purpose of the gas barrier film, but is typically from 5 to 1000 nm.

A fact that ions have been implanted can be confirmed by performing elemental analysis measurement at a position approximately 10 nm from the surface of the polymer layer using X-ray photoelectron spectroscopy (XPS).

## 4. Optical film manufacturing method

The optical film manufacturing method according to an embodiment of the present invention includes a first step, a second step, and a third step described below, using the casting film. According to the manufacturing method, each optical film according to the embodiment of the present invention can be manufactured easily. The manufacturing method including the first to third steps can provide an optical film that is thin, excellent in heat resistance, and facilitates the formation of a functional layer such as a transparent conductive layer or a gas barrier layer. In addition, by using the casting film, it is possible to efficiently and easily manufacture the optical film.

- First step: Forming a curable resin layer on a casting film using a curable resin composition containing a polymer component (A) and a curable monomer (B)
- Second step: Irradiating the curable resin layer obtained in the first step with at least one of an energy ray or an electron beam to cure at least a part of the curable resin layer
- Third step: Performing a heat treatment of heating the curable resin layer to 150°C or higher to obtain a cured resin layer, on or after the start of the second step.

Fig. 3 is a process chart illustrating an example of a step for manufacturing an optical film according to the embodiment of the present invention. Specifically, Fig. 3(a) is a schematic sectional view corresponding to a state before the curable resin layer is formed, Fig. 3(b) is a schematic sectional view corresponding to a state after the first step is performed, Fig. 3(c) is a schematic sectional view corresponding to a state after the second step is performed, and Fig. 3(d) is a schematic sectional view corresponding to a state after the third step is performed.

### (First Step)

First, the curable resin layer (indicated by the reference sign 2a in Fig. 3(b)) is formed on a surface of the casting

film (indicated by the reference sign 1 in Fig. 3(a)) using the curable resin composition containing the polymer component (A) and the curable monomer (B). The method of forming the curable resin layer is preferably coating.

The method of applying the curable resin composition onto the casting film is not particularly limited, and a known coating method, such as a spin coating method, a spray coating method, a bar coating method, a knife coating method, a roll coating method, a blade coating method, a die coating method, or a gravure coating method, can be used. Applying the curable resin composition to the surface, on which the cured resin layer is provided, of the casting film facilitates formation of a uniform coating.

The method of drying the resulting coating is not particularly limited, and a known drying method such as hot air drying, hot roll drying, and infrared irradiation can be used. Forming the resin layer by dissolving the polymer component (A) alone in a solvent without using the curable monomer (B) would be likely to cause a phenomenon in which the surface of the resin layer is dried before and the solvent remains inside the resin layer (what is called "skinning"). As described above, the cured resin layer according to the embodiment of the present invention preferably has a high Tg of the polymer component (A) contained in the curable resin composition used to form. When the Tg of the polymer component (A) is high, the above-described skinning phenomenon is particularly likely to occur. However, the curable resin composition contains the curable monomer (B), and this maintains the fluidity of the resin composition and can efficiently remove the solvent also from the inside of the resin layer when the coating obtained by a solution casting method is dried.

The drying temperature of the coating is typically from 30 to 150°C and preferably from 50 to 100°C.

The thickness of the dried coating (curable resin layer) is not particularly limited, but the thickness is almost not different from the thickness after curing, and thus the thickness is the same as the thickness of the curable resin layer described above.

(Second Step)

In the second step, the curable resin layer obtained in the first step is irradiated with at least one of an energy ray or an electron beam to cure at least a part of the curable resin layer. As a result, the curable resin layer 2a in Fig. 3(a) becomes the curable resin layer 2b after irradiation with an energy ray or an electron beam illustrated in Fig. 3(b).

It is desirable to irradiate the entire surface of the curable resin layer with an energy ray or an electron beam.

For the energy ray irradiation, for example, a high-pressure mercury lamp, an electrodeless lamp, or a xenon lamp can be utilized.

The wavelength of the energy ray is preferably from 200 to 400 nm, more preferably from 350 to 400 nm. The intensity is usually from 50 to 1000 $mW/cm^2$, and the amount of light is usually from 50 to 5000 $mJ/cm^2$, preferably from 1000 to 5000 $mJ/cm^2$. The duration of irradiation is usually from 0.1 to 1000 seconds, preferably from 1 to 500 seconds, and even more preferably from 10 to 100 seconds. The active energy ray may be applied a plurality of times so that the amount of light falls within the above range taking account of the thermal load during the irradiation process.

In this case, the curable resin composition may be irradiated with the energy ray through a filter that absorbs light at a wavelength not necessary for the curing reaction, such that degradation of the polymer component (A) and coloration of the cured resin layer due to the energy ray irradiation can be prevented. According to this method, light at a wavelength that is not necessary for the curing reaction and degrades the polymer component (A) is absorbed by the filter, and thus this prevents degradation of the polymer component (A) and makes it easier to obtain a colorless and transparent cured resin layer.

A resin film such as a poly(ethylene terephthalate) film can be used as the filter. When a resin film is used, it is preferable to provide a process of laminating a resin film, such as a poly(ethylene terephthalate) film, on the curable resin layer separately from the casting film used in the first step, between the first step and the second step. The resin film is typically peeled off after the second step. The resin film can also be regarded as a casting film, and the cured resin layer is sandwiched between the casting film used in the first step and the resin film (second casting film), and thereby producing an optical film 10B having the configuration illustrated in Fig. 1(b).

Furthermore, the curable resin layer can be cured by irradiating the curable resin layer with an electron beam. In a case where the curable resin layer is irradiated with an electron beam, the curable resin layer usually can be cured without the use of a photopolymerization initiator. In a case where the curable resin layer is irradiated with an electron beam, an electron beam accelerator or the like can be used. The dose is usually in a range of from 10 to 1000 krad. The duration of irradiation is usually from 0.1 to 1000 seconds, preferably from 1 to 500 seconds, and even more preferably from 10 to 100 seconds.

Curing of the curable resin layer may be carried out in an atmosphere of an inert gas such as nitrogen gas as necessary. When curing is carried out in an atmosphere of an inert gas, it is easy to prevent oxygen, moisture, and the like from hindering the curing.

(Third Step)

In the third step, a heat treatment is performed in which the curable resin layer is heated to 150°C or higher, on or after the start of the second step, to produce the cured resin layer (reference numeral 2 in Fig. 3(d)).
Through the third step, the curing of the curable resin layer is substantially completed, and a cured resin layer is formed.
In the third step, the temperature of the heat treatment is preferably 160°C or higher, more preferably 170°C or higher, and still more preferably 180°C or higher from the viewpoint of further accelerating curing. In addition, the temperature is preferably 210°C or lower, more preferably 200°C or lower, and still more preferably 190°C or lower from the viewpoint of suppressing alteration of the obtained cured resin layer.
A time duration of heat treatment varies depending on the type of the curable resin composition used and the heat treatment temperature, and is preferably 30 minutes or more, more preferably 45 minutes or more, and still more preferably 1 hour or more from the viewpoint of sufficiently advancing the curing. Also, from the viewpoint of productivity, the time duration is preferably 3 hours or less, more preferably 2.5 hours or less, and still more preferably 2 hours or less.
The heat treatment may be started on or after the start of the second step. For example, the heat treatment may be performed after completion of the second step, or may be performed in parallel with the second step after a lapse of a certain time from the start of the second step.
The method of the heat treatment is not particularly limited, and various methods can be used. For example, the heat treatment can be performed by heating the curable resin layer in the air or in an inert gas atmosphere using a heating oven or an autoclave.

[Examples]

The present invention will now be described in greater detail by way of examples, but the present invention is not limited by these examples.
Measurements of the physical properties and the evaluation of the cured resin layer and the optical film of each example and each comparative example were performed according to the following procedures.

<Peak temperature of loss tangent and storage modulus reduction rate>

The cured resin layer was obtained by peeling off and removing the polyethylene terephthalate (PET) films serving as the casting films and provided on both sides of the cured resin layer. Eight resulting cured resin layers were laminated to make a laminate having a thickness of 40 μm. Then, the laminate was cut into a 5 mm × 30 mm test piece, and the test piece of the laminate of the cured resin layer was held in a thermomechanical analyzer (DMA242, available from NETZSCH Japan K.K.) with a distance between chucks set at 15 mm. The laminate of the cured resin layer was then subjected to a temperature increase from 25°C to 280°C at 3°C/min to measure the storage modulus and the loss modulus. Then, the loss tangent (loss modulus/storage modulus) curve was created in the temperature range from 25°C to 280°C, and peak-separation was performed on the curve using a Gaussian function as the fitting function, and the temperature of each peak apex was defined as the loss tangent peak temperature.
Furthermore, the reduction rate of the storage modulus from 25°C to 150°C was calculated by Equation (1) below, and the storage modulus reduction rate was determined.

$$\text{Storage modulus reduction rate} = (\text{storage modulus at } 25^\circ\text{C} - \text{storage modulus at } 150^\circ\text{C})/\text{storage modulus at } 25^\circ\text{C} \times 100\ (\%) \ \ldots \quad \text{Equation (1)}$$

<Total light transmittance>

As the optical characteristics of the optical film, the total light transmittance was measured by the following procedure.
The cured resin layer obtained by peeling off and removing the polyethylene terephthalate (PET) films serving as the casting films and provided on both sides of the cured resin layer was used as a test piece. The transmittance of white light transmitted through the test piece was measured using a haze meter (NDH 5000, available from Nippon Denshoku Industries Co., Ltd.) and defined as a total light transmittance (%).

Example 1

A curable resin composition E1 for forming a cured resin layer was prepared by the following procedure.

As a polymer component (A), 100 parts by mass of polyimide resin (PI) pellets (product name is KPI-MX300F, Tg = 354°C, weight average molecular weight is 280000, available from Kawamura Sangyo Co. Ltd.) was dissolved in methyl ethyl ketone (MEK) to prepare a 15 mass% solution of PI. Next, as a curable monomer (B), 122 parts by mass of tricyclodecane dimethanol diacrylate (A-DCP, available from Shin-Nakamura Chemical Co., Ltd.) and, as a polymerization initiator, 5 parts by mass of bis(2,4,6-trimethylbenzoyl)-phenylphosphine oxide (Irgacure 819, available from BASF) was added and mixed into the 15 mass% solution of PI above to prepare the curable resin composition E1. The curable monomer (B) and polymerization initiator used in this Example and other experimental examples did not contain a solvent and were all raw materials with a solid content of 100%.

A first PET film (Cosmoshine PET100A-4160, available from Toyobo Co., Ltd., thickness 100 μm) having a primer layer on one surface was then used as the first casting film, and the other surface of this PET film, which is the surface opposite from the primer layer, was coated with the curable resin composition E1. The resulting coating was heated and dried at 90°C for 3 minutes.

Furthermore, a second PET film (Cosmoshine PET50A-4160, available from Toyobo Co., Ltd., thickness 50 μm) having a primer layer on one surface was laminated as the second casting film on this dried coating to allow the other surface of the second PET film, which is the surface opposite from the primer layer, to face the dried coating. Then, the dried coating was irradiated with ultraviolet light through the second PET film to carry out a curing reaction using a belt conveyor type ultraviolet light irradiation device (product name: ECS-401GX, available from Eye Graphics Co., Ltd.) and a high-pressure mercury lamp (product name: H04-L41, available from Eye Graphics Co., Ltd.) under conditions of a height of UV lamp of 100 mm, an output of an UV lamp of 3 kW, an intensity of 400 $mW/cm^2$ at a wavelength of 365 nm, and an amount of light of 800 $mJ/cm^2$ (measured with a UV actinometer UV-351, available from ORC Manufacturing Co., Ltd.), and a cured resin layer with a thickness of 5 μm was formed.

Furthermore, using a heating oven to the cured resin layer, the heat treatment was performed at 180°C for 1 hour to obtain an optical film.

Comparative Example 1

An optical film was obtained in the same manner as in Example 1 except for not performing a heat treatment to heat the cured resin layer at 180°C for 1 hour.

Comparative Example 2

An optical film was obtained in the same manner as in Example 1 except that polysulfone resin pellets (ULTRASON S3010, available from BASF, Tg = 180°C) were used in place of the polyimide resin (PI) pellets.

The measurement results for examples and comparative examples are shown in Table 1. In the column of heat treatment in Table 1, "Y" represents that heat treatment was performed, and "N" represents that heat treatment was not performed.

Table 1

| | | Unit | Example 1 | Comparative Example 1 | Comparative Example 2 |
|---|---|---|---|---|---|
| Heat treatment | Heating at 180°C for 1 hour | - | Y | N | Y |

(continued)

<table>
<tr><td colspan="4"></td><td>Unit</td><td>Example 1</td><td>Comparative Example 1</td><td>Comparative Example 2</td></tr>
<tr><td rowspan="5">Measurement items and measurement methods</td><td rowspan="4">DMA</td><td rowspan="3">Loss tangent peak temperature</td><td>First peak</td><td rowspan="3">°C</td><td>250</td><td>250</td><td>162</td></tr>
<tr><td>Second peak</td><td>-</td><td>190</td><td>-</td></tr>
<tr><td>Third peak</td><td>-</td><td>130</td><td>-</td></tr>
<tr><td colspan="2">Storage modulus reduction rate</td><td>%</td><td>25</td><td>62</td><td>66</td></tr>
<tr><td>Total light transmittance</td><td colspan="2">-</td><td>%</td><td>91.1</td><td>91.1</td><td>91.0</td></tr>
<tr><td colspan="8">* Meanings of abbreviations in Table 1<br>DMA: Dynamic viscoelasticity measurement</td></tr>
</table>

As is apparent from Table 1, in the optical film of Example 1, only a loss tangent peak having a peak temperature of 250°C is observed. That is, the optical film of Example 1 has one or more loss tangent peaks, and the peak temperatures of all the loss tangent peaks are 150°C or higher. Thus, the optical film of Example 1 can have a small storage modulus reduction rate.

On the other hand, in the film of Comparative Example 1, loss tangent peaks at peak temperatures of 130°C, 190°C, and 250°C are observed. That is, the film of Comparative Example 1 has one or more loss tangent peaks, but the peak temperatures of all the loss tangent peaks are not 150°C or higher. Therefore, the storage modulus reduction rate is larger than that of the optical film of Example 1. Therefore, it can be understood that the film of Comparative Example 1 has a large degree of deformation due to heat, and there is room for improvement in use for formation of a functional layer requiring a formation step involving heating of a transparent conductive layer, a gas barrier layer, and the like.

Additionally, in Comparative Example 2, a polysulfone resin having a Tg of 180°C as the polymer component (A) was used, and the storage modulus reduction rate was increased compared to the optical film of Example 1. Therefore, it can be understood that the film of Comparative Example 2 has a large degree of deformation due to heat, and there is room for improvement in use for formation of a functional layer requiring a formation step involving heating of a transparent conductive layer, a gas barrier layer, and the like.

[Reference Signs List]

1, 1A, 1B: Casting film
2: Cured resin layer
2a: Curable resin layer
2b: Curable resin layer after irradiation with energy rays or electron beams
3: Transparent conductive layer
4: Gas barrier layer
10A, 10B: Optical film
20: Transparent conductive film
21: Transparent conductive film with patterned transparent conductive layer
22 Gas barrier film
31: Patterned transparent conductive layer

## Claims

**1.** An optical film comprising:

a casting film; and
a cured resin layer,
wherein the cured resin layer is a layer comprising a cured product of a curable resin composition comprising a polymer component (A) and a curable monomer (B), and satisfies (I) and (II) for characteristic values determined by dynamic viscoelasticity measurement at a heating rate of 3°C/sec from 25°C to 280°C:

(I) one or more loss tangent peaks are present in a curve representing a change in loss tangent with respect to temperature, and peak temperatures of all loss tangent peaks are 150°C or higher,
(II) a storage modulus reduction rate is 40% or less, the storage modulus reaction rate being a reduction rate of the storage modulus from 25°C to 150°C, calculated by Equation (1):

$$\text{storage modulus reduction rate} = (\text{storage modulus at } 25°C - \text{storage modulus at } 150°C)/\text{storage modulus at } 25°C \times 100\ (\%) \ldots \quad \text{Equation (1)}.$$

**2.** An optical film comprising:

a casting film; and
a cured resin layer,
wherein the cured resin layer is a layer comprising a cured product of a curable resin composition comprising a polymer component (A) and a curable monomer (B),
a glass transition temperature of the polymer component (A) is 250°C or higher, and
in a curve representing a change in loss tangent with respect to a temperature determined by dynamic viscoelasticity measurement at a heating rate of 3°C/sec from 25°C to 280°C, one or more loss tangent peaks are present, and peak temperatures of all loss tangent peaks are 150°C or higher.

**3.** The optical film according to claim 1 or 2, wherein a thickness of the cured resin layer is 20 μm or less.

**4.** An optical film manufacturing method, the method comprising:

(i) forming a curable resin layer comprising a curable resin composition comprising a polymer component (A) and a curable monomer (B) on a casting film;
(ii) irradiating the curable resin layer with at least one of an energy ray or an electron beam to cure at least a part of the curable resin layer; and
(iii) performing a heat treatment of heating the curable resin layer to 150°C or higher on or after the start of the step (ii) to form a cured resin layer.

**5.** A transparent conductive film comprising:

the optical film defined in any one of claims 1 to 3; and
a transparent conductive layer provided on the cured resin layer of the optical film.

**6.** A gas barrier film comprising:

the optical film defined in any one of claims 1 to 3; and
a gas barrier layer provided on the cured resin layer of the optical film.

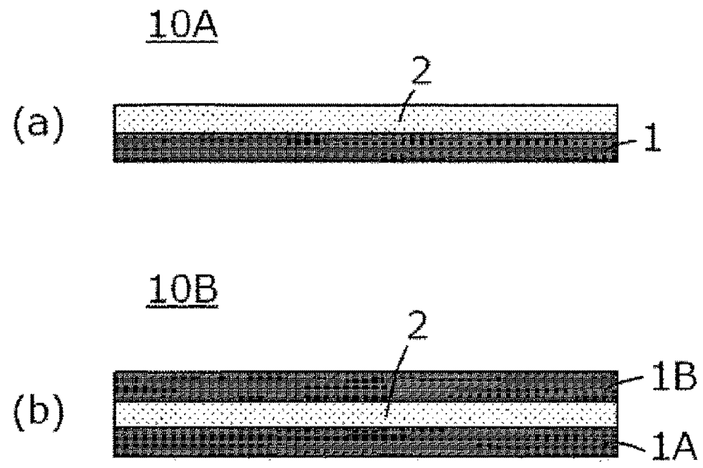


Fig. 1

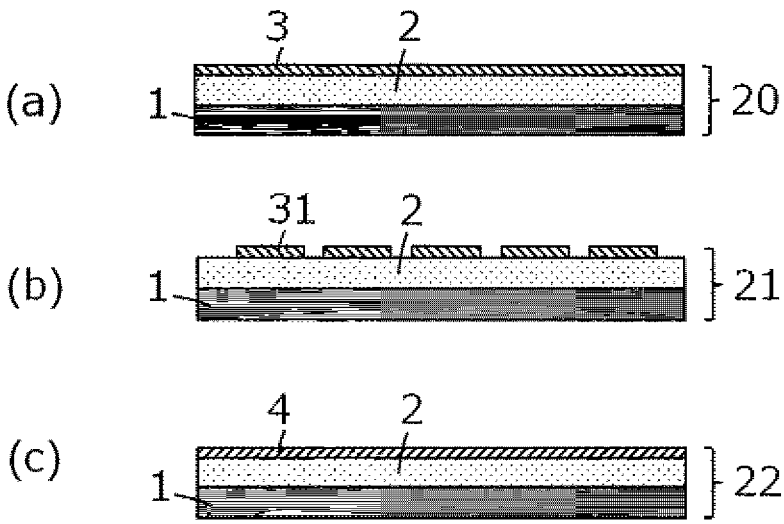


Fig. 2

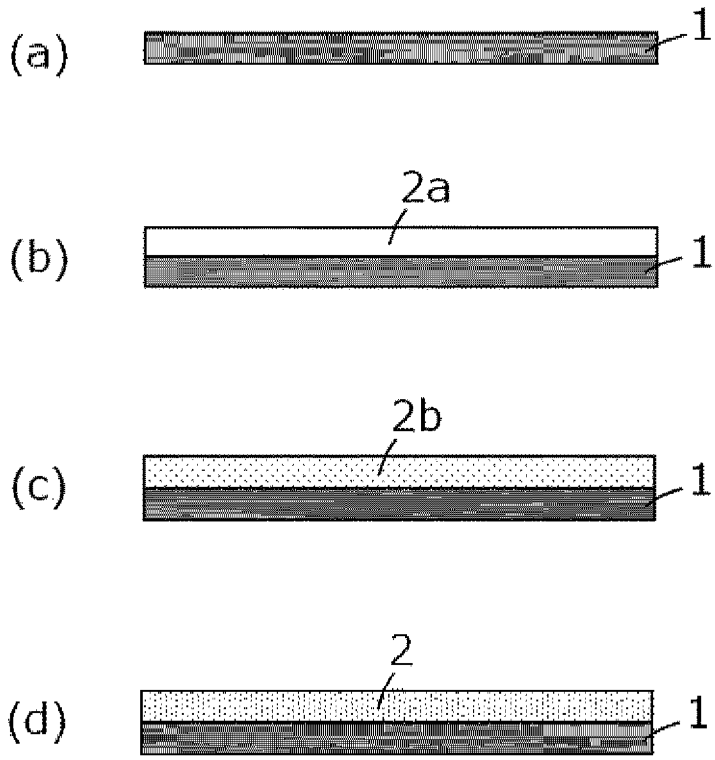


Fig. 3

**INTERNATIONAL SEARCH REPORT**

International application No. PCT/JP2021/021113

A. CLASSIFICATION OF SUBJECT MATTER
Int.Cl. B32B27/00(2006.01)i
FI: B32B27/00Z

According to International Patent Classification (IPC) or to both national classification and IPC

B. FIELDS SEARCHED

Minimum documentation searched (classification system followed by classification symbols)
Int.Cl. B32B27/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2014-24894 A (MITSUBISHI GAS CHEMICAL COMPANY, INC.) 06 February 2014 (2014-02-06), claims, paragraphs [0001]-[0005], examples (particularly, example 8) | 1, 2, 4, 5<br>3, 6 |
| Y | WO 2013/065812 A1 (LINTEC CORPORATION) 10 May 2013 (2013-05-10), paragraphs [0001], [0074]-[0083] | 3, 6 |
| A | WO 2016/129329 A1 (KONICA MINOLTA, INC.) 18 August 2016 (2016-08-18), entire text | 1-6 |
| A | WO 2019/130750 A1 (FUJIFILM CORPORATION) 04 July 2019 (2019-07-04), entire text | 1-6 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 28 June 2021 | 13 July 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No.
PCT/JP2021/021113

C (Continuation). DOCUMENTS CONSIDERED TO BE RELEVANT

| Category* | Citation of document, with indication, where appropriate, of the relevant passages | Relevant to claim No. |
|---|---|---|
| A | JP 2020-82552 A (SUMITOMO CHEMICAL CO., LTD.) 04 June 2020 (2020-06-04), entire text | 1-6 |
| A | WO 2018/237377 A1 (DESIGNER MOLECULES, INC.) 27 December 2018 (2018-12-27), entire text | 1-6 |
| P, X | WO 2020/138206 A1 (LINTEC CORPORATION) 02 July 2020 (2020-07-02), entire text | 1-6 |

Form PCT/ISA/210 (second sheet) (January 2015)

**INTERNATIONAL SEARCH REPORT**
Information on patent family members

International application No.
PCT/JP2021/021113

| | | |
|---|---|---|
| JP 2014-24894 A | 06 February 2014 | (Family: none) |
| WO 2013/065812 A1 | 10 May 2013 | US 2014/0308494 A1 paragraphs [0001], [0103]-[0112] |
| WO 2016/129329 A1 | 18 August 2016 | KR 10-2017-0102535 A entire text |
| WO 2019/130750 A1 | 04 July 2019 | CN 111480115 A entire text |
| JP 2020-82552 A | 04 June 2020 | KR 10-2020-0063031 A entire text |
| WO 2018/237377 A1 | 27 December 2018 | KR 10-2020-0023403 A entire text |
| WO 2020/138206 A1 | 02 July 2020 | (Family: none) |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2013065812 A
- JP 2004035638 A